(19)

**Europäisches Patentamt**
**European Patent Office**
**Office européen des brevets**

(11)  **EP 4 184 188 B1**

(12)  # EUROPEAN PATENT SPECIFICATION

(45) Date of publication and mention
of the grant of the patent:
**09.10.2024  Bulletin 2024/41**

(21) Application number: **20948959.0**

(22) Date of filing: **10.08.2020**

(51) International Patent Classification (IPC):
**B60L 3/00** *(2019.01)*        **B60L 58/12** *(2019.01)*
**B60L 58/16** *(2019.01)*       **G01R 31/367** *(2019.01)*
**H01M 10/48** *(2006.01)*

(52) Cooperative Patent Classification (CPC):
**B60L 58/16; B60L 3/0046; B60L 58/12;**
**G01R 31/367; H01M 10/48;** B60L 2240/545;
B60L 2240/547; B60L 2260/44; G01R 31/374;
H01M 2220/20; Y02T 10/70

(86) International application number:
**PCT/CN2020/108291**

(87) International publication number:
**WO 2022/032460 (17.02.2022 Gazette 2022/07)**

(54) **LITHIUM PLATING DETECTION METHOD AND APPARATUS FOR LITHIUM BATTERY**

VERFAHREN UND VORRICHTUNG ZUR ERKENNUNG VON LITHIUMPLATTIERUNG FÜR EINE LITHIUMBATTERIE

PROCÉDÉ ET APPAREIL DE DÉTECTION DE PLACAGE DE LITHIUM POUR BATTERIE AU LITHIUM

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**

(43) Date of publication of application:
**24.05.2023  Bulletin 2023/21**

(73) Proprietor: **Huawei Technologies Co., Ltd.**
**Shenzhen, Guangdong 518129 (CN)**

(72) Inventors:
• **YUAN, Shifei**
**Shenzhen, Guangdong 518129 (CN)**
• **LIU, Bingxiao**
**Shenzhen, Guangdong 518129 (CN)**
• **YANG, Rui**
**Shenzhen, Guangdong 518129 (CN)**
• **WU, Zhiwei**
**Shenzhen, Guangdong 518129 (CN)**

(74) Representative: **Pfenning, Meinig & Partner mbB**
**Patent- und Rechtsanwälte**
**Theresienhöhe 11a**
**80339 München (DE)**

(56) References cited:
**CN-A- 109 143 083       CN-A- 109 613 436**
**CN-A- 111 077 455       CN-A- 111 175 662**
**CN-U- 203 734 326       CN-U- 203 910 935**
**US-A1- 2019 229 378     US-A1- 2019 379 090**
**US-A1- 2020 106 138**

• **PETZL MATHIAS ET AL: "Nondestructive**
**detection, characterization, and quantification of**
**lithium plating in commercial lithium-ion**
**batteries", JOURNAL OF POWER SOURCES,**
**ELSEVIER, AMSTERDAM, NL, vol. 254, 20**
**December 2013 (2013-12-20), pages 80 - 87,**
**XP028610432, ISSN: 0378-7753, DOI:**
**10.1016/J.JPOWSOUR.2013.12.060**
• **JANAKIRAMAN UMAMAHESWARI ET AL:**
**"Journal of The Electrochemical Society OPEN**
**ACCESS Review-Lithium Plating Detection**
**Methods in Li-Ion Batteries Review-Lithium**
**Plating Detection Methods in Li-Ion Batteries", J.**
**ELECTROCHEM. SOC, vol. 167, 1 January 2020**
**(2020-01-01), pages 160552, XP055983139,**
**Retrieved from the Internet**
**<URL:https://iopscience.iop.org/article/10.1149/**
**1945-7111/abd3b8/pdf>**

**EP 4 184 188 B1**

## Description

### TECHNICAL FIELD

This application relates to the field of battery technologies, and in particular, to a method and apparatus for detecting lithium plating in a lithium battery. This application may be applied to a new energy vehicle, an electric vehicle, an intelligent vehicle, and a connected vehicle.

### BACKGROUND

Because of advantages such as low pollution, high energy density, a long cycle life, and a low self-discharge rate, lithium batteries are widely used in electronic devices such as a mobile phone, a tablet, and a portable device, and electric vehicles such as an electric motorcycle, and become an indispensable part of these devices or vehicles. Therefore, more and more attention has been paid to safety of the lithium batteries. Lithium plating, as an abnormal phenomenon during charging of the lithium batteries, is one of hot issues in recent years.

During charging of the lithium batteries, lithium ions are deintercalated from a positive electrode and intercalated into a negative electrode. When the lithium ions deintercalated from the positive electrode fail to be intercalated into the negative electrode, these lithium ions are precipitated on the surface of the negative electrode to form lithium metal. This is called lithium plating. Lithium plating may be caused by internal factors and external factors. The internal factors usually include that a negative electrode potential vs. Li+/Li is less than 0. As a result, not all of the lithium ions are intercalated into the negative electrode, but some are intercalated into the negative electrode and some are precipitated in a lithium metal state. The external factors usually include a low temperature, a high state of charge (state of charge, SOC), and high rate charging. Because the low temperature slows down lithium ion diffusion power, and the negative electrode potential vs. Li+/Li in the high state of charge is low, both the low temperature and the high state of charge are not conducive to intercalating the lithium ions into the negative electrode. The high-rate charging generates a strong electric field to drive a large quantity of lithium ions to be deintercalated from the positive electrode and intercalated into the negative electrode. When a quantity of lithium ions deintercalated is greater than a quantity of lithium ions that can be received by the negative electrode, lithium plating occurs.

Coulombic efficiency is reduced due to occurrence and accumulation of lithium plating, resulting in a decrease in a capacity of the lithium batteries. Because the precipitated lithium metal is easy to expand the negative electrode and cause particle rupture, more fresh interfaces of the negative electrode are exposed to electrolyte to form a new solid electrolyte interface (solid electrolyte interface, SEI) film, resulting in an increase in impedance. In addition, continuous growth of the precipitated lithium metal causes formation of lithium dendrites, which further causes internal short circuits and poses safety risks. The precipitated lithium metal reacts slowly with the electrolyte, greatly reducing an initial temperature of thermal runaway. Therefore, there is a need for detecting lithium plating in the lithium batteries.

In the conventional technology, according to a current real-time lithium plating detection technology, a lithium plating detection method includes the following steps: during charging of a lithium battery, monitoring a charge voltage and a state of charge of the lithium battery, where the charge voltage is used as a first voltage; obtaining, from a correspondence between a preset open-circuit voltage and the state of charge, a corresponding voltage value to a current state of charge as a second voltage; and determining, based on a magnitude relation between a difference (namely, a polarization voltage) between the first voltage and the second voltage and a polarization voltage threshold that is obtained through measurement in advance, whether lithium plating occurs during charging. If the difference is greater than the polarization voltage threshold, it may be determined that lithium plating occurs in the lithium battery. However, the polarization voltage of the lithium battery in this method cannot be used to distinguish polarization voltages of the positive and negative electrodes, and lithium plating mainly occurs at the negative electrode of the lithium battery. Therefore, when the polarization voltage and the polarization voltage threshold of the lithium battery are used to determine whether lithium plating occurs in the lithium battery, reliability of lithium plating detection may be low.

US 2019/229378 A1 discloses a method for minimizing lithium plating while charging a lithium battery by controlling charging parameters. Temperature, SOC, and charge current are used in an electrochemical model that accounts for lithium plating.

### SUMMARY

This application provides a method and apparatus for detecting lithium plating in a lithium battery. A lithium plating estimation model of a lithium battery is determined based on a voltage of the lithium battery, a charge current of the lithium battery, a temperature of the lithium battery, an SOH of the lithium battery, and a correspondence between the temperature of the lithium battery and the SOH of the lithium battery and a target parameter, to determine a real-time potential value of a negative electrode of the lithium battery. In this way, in this application, whether lithium plating occurs on the lithium battery can be detected based on the real-time potential value of the negative electrode. This improves reliability of lithium evolution plating.

To achieve the foregoing objectives, the following technical solutions are used in embodiments of this application.

According to a first aspect, a method for detecting lithium plating in a lithium battery is provided, including: determining, based on a state of health SOH of the lithium battery, a temperature of the lithium battery, and a correspondence between the temperature of the lithium battery and the SOH and a target parameter, a target parameter corresponding to the lithium battery; substituting the target parameter corresponding to the lithium battery into a preset lithium plating estimation model, to obtain a lithium plating estimation model of the lithium battery; then, entering a charge current of the lithium battery, a voltage of the lithium battery, the temperature of the lithium battery, and the SOH of the lithium battery into the lithium plating estimation model of the lithium battery, to obtain a real-time potential value of the negative electrode of the lithium battery; and determining that lithium plating occurs in the lithium battery if the real-time potential value of the negative electrode of the lithium battery obtained by using the foregoing lithium plating estimation model is less than zero.

The target parameter corresponding to the lithium battery is a ratio of a polarization voltage of a negative electrode of the lithium battery to a polarization voltage of the lithium battery, and the polarization voltage is a difference between an actual voltage and an open-circuit voltage. More specifically, the polarization voltage of the negative electrode of the lithium battery is a difference between an actual voltage of the negative electrode of the lithium battery and an open-circuit voltage of the negative electrode of the lithium battery. The polarization voltage of the lithium battery is a difference between an actual voltage of the lithium battery and an open-circuit voltage of the lithium battery.

Generally, when lithium plating occurs or ends in the lithium battery, the potential value of the negative electrode of the lithium battery is zero, and lithium plating occurs at the negative electrode. Compared with other data such as the polarization voltage of the lithium battery, the real-time potential value of the negative electrode may reflect a state of the negative electrode of the lithium battery more directly and accurately (that is, whether lithium plating occurs in the lithium battery). Therefore, whether lithium plating occurs in the lithium battery may be relatively directly and accurately determined by determining whether the real-time potential value of the negative electrode of the lithium battery is less than zero. This improves reliability of lithium plating detection. In addition, when the lithium battery is not modified or disassembled, a target parameter in the lithium plating estimation model of the lithium battery may be determined based on the correspondence between the temperature and SOH of the lithium battery and the target parameter. In this way, based on the temperature, the SOH, the charge current, and the voltage of the lithium battery, the real-time potential value of the negative electrode of the lithium battery may be obtained directly by using the lithium plating estimation model of the lithium battery, to simplify a process of lithium plating detection while ensuring the reliability of lithium plating detection. This improves efficiency of lithium plating detection.

In a possible implementation of the first aspect, before the determining, based on a SOH of the lithium battery, a temperature of the lithium battery, and a correspondence between the SOH of the lithium battery and the temperature of the lithium battery and a target parameter, a target parameter corresponding to the lithium battery, the correspondence between the SOH of the lithium battery and the temperature of the lithium battery and the target parameter needs to be first determined, which includes: charging the lithium battery at different temperatures and in different SOHs by using a preset charge rate, a first charge rate, a second charge rate, and a third charge rate; during charging of the lithium battery at the preset charge rate, determining corresponding open-circuit voltages OCVs of the lithium battery in different states of charge SOCs of the lithium battery and corresponding OCVs of the negative electrode of the lithium battery in different SOCs of the lithium battery, where the OCV of the negative electrode of the lithium battery is a reference potential of the negative electrode of the lithium battery relative to a lithium electrode; during charging of the lithium battery at the first charge rate, the second charge rate, or the third charge rate, separately obtaining corresponding temperatures and pressure of the lithium battery in different SOCs, where the pressure is used to indicate a change of an external swelling volume of the lithium battery during charging; determining, based on the corresponding temperatures and pressure of the lithium battery in different SOCs, corresponding lithium plating effect pressure of the lithium battery in different SOCs, where the corresponding lithium plating effect pressure of the lithium battery in different SOCs is used to indicate a pressure change of the lithium battery caused by a lithium plating effect; determining the polarization voltage of the negative electrode of the lithium battery and the polarization voltage of the lithium battery based on the corresponding OCVs of the lithium battery in different SOCs of the lithium battery, the corresponding OCVs of the negative electrode of the lithium battery in different SOCs of the lithium battery, and the corresponding lithium plating effect pressure of the lithium battery in different SOCs; and finally establishing a correspondence between the temperature of the lithium battery, the SOH of the lithium battery, and the target parameter. The target parameter is a ratio of a polarization voltage of a negative electrode of the lithium battery to a polarization voltage of the lithium battery.

Generally, conventional information such as a current, a voltage and a temperature indicates that sensitivity of lithium plating in the lithium battery is relatively low. When the lithium battery has a large quantity of lithium plating, the information such as the current, the voltage, and the temperature changes significantly to indicate that lithium plating occurs in the lithium battery. Compared with the conventional information such as the current, the voltage, and the temperature, the lithium plating effect pressure is more sensitive to indicating whether lithium plating occurs in the lithium battery, and has higher reliability of lithium plating detection. In addition, the polarization voltage of the lithium battery and the polarization voltage of the negative electrode of the lithium battery are obtained by processing voltages of the lithium battery at the end of lithium plating and at the start of lithium plating, a voltage of the negative electrode of the lithium battery, an OCV of the negative electrode of the lithium battery, and an OCV of the lithium battery. Because accuracy of a lithium plating end moment and a lithium plating start moment determined by using the lithium plating effect pressure is relatively high, accuracy of the polarization voltage of the negative electrode of the lithium battery and the polarization voltage of the lithium battery determined based on a voltage and an open-circuit voltage corresponding to the lithium plating end moment and the lithium plating start moment is relatively high, and reliability of lithium plating detection of the obtained lithium plating estimation model of the lithium battery is relatively high.

In a possible implementation of the first aspect, the corresponding temperatures and pressure of the lithium battery in different SOCs include a first temperature and first pressure corresponding to the first charge rate, a second temperature and second pressure corresponding to the second charge rate, and third pressure corresponding to the third charge rate. The first pressure is total pressure caused by a lithium ion deintercalation effect, a temperature effect, and the lithium plating effect. The second pressure is total pressure caused by the lithium ion deintercalation effect and the temperature effect. The third pressure is pressure caused by the lithium ion deintercalation effect.

In a possible implementation of the first aspect, the determining, based on the corresponding temperatures and pressure of the lithium battery in different SOCs, corresponding lithium plating effect pressure of the lithium battery in different SOCs includes: determining an association relationship between temperature effect pressure of the lithium battery and the temperature of the lithium battery based on the second temperature and differences between the second pressure and the third pressure in different SOCs, where the temperature effect pressure of the lithium battery is used to indicate a pressure change caused by the temperature effect of the lithium battery at different temperatures; determining, based on the first temperature and the association relationship, corresponding temperature effect pressure of the lithium battery in different SOCs during charging of the lithium battery at the first charge rate; and finally determining, as the corresponding lithium plating effect pressure of the lithium battery in different SOCs, differences between the first pressure and a sum of the third pressure and the corresponding temperature effect pressure of the lithium battery in different SOCs.

In the foregoing possible implementation, pressure values of the lithium battery at different charge rates are detected, to obtain relationships between the pressure values and different SOCs of the lithium battery at different charge rates, and the association relationship between the temperature effect pressure and the temperature of the lithium battery. Therefore, based on the first pressure and the first temperature, the lithium plating effect pressure of the lithium battery is simply and effectively determined by subtracting a change of the pressure value caused by the lithium ion deintercalation effect and the temperature effect. In addition, the lithium plating effect pressure is a pressure generated by lithium plating in the lithium battery, that is, the lithium plating effect pressure of the lithium battery is zero when lithium plating does not occur in the lithium battery. Therefore, based on the lithium plating effect pressure, a lithium plating condition of the lithium battery may be effectively detected during charging of the lithium battery. Compared with the conventional information such as the current, the voltage, and the temperature, the lithium plating effect pressure is more sensitive to determining whether lithium plating occurs in the lithium battery, and has higher reliability of lithium plating detection.

In a possible implementation of the first aspect, the determining the polarization voltage of the negative electrode of the lithium battery and the polarization voltage of the lithium battery based on the corresponding OCVs of the lithium battery in different SOCs of the lithium battery, the corresponding OCVs of the negative electrode of the lithium battery in different SOCs of the lithium battery, and the corresponding lithium plating effect pressure of the lithium battery in different SOCs includes: determining, as the polarization voltage of the negative electrode, a corresponding OCV of the negative electrode of the lithium battery in a start SOC, where the start SOC is a corresponding SOC when a pressure value of the lithium plating effect pressure changes from zero to non-zero; and determining, as the polarization voltage of the lithium battery, a difference between the (actual) voltage of the lithium battery in an end SOC and a corresponding OCV of the lithium battery in the end SOC, where the end SOC is an SOC corresponding to a maximum pressure value of the lithium plating effect pressure.

In the foregoing possible implementation, when the lithium plating effect pressure is zero, it is used to indicate that the lithium plating effect occurs in the lithium battery. Therefore, the corresponding SOC when a pressure value of the lithium plating effect pressure changes from zero to non-zero may be determined as the start SOC in which lithium plating occurs in the lithium battery, to implement accurate detection of a start point at which lithium plating occurs. In addition, in the foregoing possible implementation, when the lithium plating effect pressure is a maximum value during charging of the lithium battery, it is used to indicate that the lithium plating effect ends in the lithium battery. Therefore, an SOC corresponding to the maximum pressure value of the lithium plating effect pressure may be determined as the end SOC in which lithium plating ends in the lithium battery, to implement accurate detection of the end SOC of lithium plating.

In a possible implementation of the first aspect, the preset lithium plating estimation model is

$$\begin{cases} SOC = \dfrac{\int I dt}{Q} \\ V_{neg} = OCV_{neg} - V_{p,neg} = OCV_{neg}(SOC, T, SOH) - \alpha(V_{cell} - OCV_{cell}(SOC, T, SOH)) \end{cases}$$

, where I is the charge current of the lithium battery, Q is a rated capacity of the lithium battery, $\int I dt$ represents an electric capacity of the lithium battery at a current moment, SOC is the state of charge of the lithium battery, $V_{neg}$ is the real-time potential value of the negative electrode of the lithium battery, $OCV_{neg}$ is the open-circuit voltage of the negative electrode of the lithium battery, $V_{p,neg}$ is the polarization voltage of the negative electrode of the lithium battery, T is the temperature of the lithium battery, SOH is the state of health of the lithium battery, $OCV_{neg}(SOC, T, SOH)$ is a function of $OCV_{neg}$ on SOC, T, and SOH, $\alpha$ is a target parameter in the lithium plating estimation model of the lithium battery, $V_{cell}$ is the voltage of the lithium battery, $OCV_{cell}(SOC, T, SOH)$ is a function of $OCV_{cell}$ on SOC, T, and SOH, and $V_{cell} - OCV_{cell}(SOC, T, SOH)$ represents the polarization voltage of the lithium battery.

The charge current, the voltage, the SOH, and the temperature of the lithium battery are entered into the lithium plating estimation model of the lithium battery obtained by using the preset lithium plating estimation model, to obtain the real-time potential value of the negative electrode of the lithium battery, so as to determine, on the premise of not damaging integrity of the battery, based on the real-time potential value that is of the negative electrode of the lithium battery and is directly related to lithium plating in the lithium battery, whether lithium plating occurs in the lithium battery. This ensures reliability of lithium plating detection of the lithium battery.

In a possible implementation of the first aspect, after the determining that lithium plating occurs in the lithium battery, the method further includes: outputting lithium plating alarm information. The lithium plating alarm information includes at least one of a lithium plating occurrence moment, a lithium plating end moment, an SOC corresponding to the lithium plating occurrence moment, and a lithium plating severity level. The lithium plating severity level is determined based on lithium plating duration and the real-time potential value of the negative electrode.

In a possible implementation of the first aspect, the method further includes: adjusting the charge current of the lithium battery based on the real-time potential value of the negative electrode of the lithium battery.

In the foregoing possible implementation, when the lithium battery is charged by using different charge currents, it may be determined, based on the real-time potential value of the negative electrode of the lithium battery, whether lithium plating occurs in the lithium battery when charging is performed by using a current charge current. If it is determined that lithium plating occurs in the lithium battery, a value of the current charge current may be adjusted, for example, the current charge current may be reduced, so that the lithium battery is gradually moved away from a lithium plating state and changes to a safe charging state. This ensures safety of the lithium battery during charging.

In a possible implementation of the first aspect, the method further includes: determining a maximum safe charge current of the lithium battery based on the lithium plating occurrence moment and the SOC corresponding to the lithium plating occurrence moment.

In the foregoing possible implementation, when the lithium battery is charged, the charge current may be adjusted based on allowable maximum safe charge currents of the lithium battery under different conditions, so that the charge current is always within a safe charge current range. This ensures safety of the lithium battery during charging.

In a possible implementation of the first aspect, a correspondence between an OCV of the lithium battery and a charge capacity of the lithium battery, a correspondence between an OCV of the negative electrode of the lithium battery and a charge capacity of the negative electrode, and a correspondence between an OCV of a positive electrode of the lithium battery and a charge capacity of the positive electrode are obtained during charging of the lithium battery at a preset charge rate. Based on the foregoing correspondences, differential processing is performed on the voltage and the charge capacity of the lithium battery, to obtain a dV/dQ curve of the lithium battery. Similarly, a dV/dQ curve of the negative electrode of the lithium battery and a dV/dQ curve of the positive electrode of the lithium battery are obtained. Subsequently, translation or scaling processing is performed on the dV/dQ curve of the negative electrode of the lithium battery and the dV/dQ curve of the positive electrode of the lithium battery based on a characteristic peak of the dV/dQ curve of the lithium battery, so that a characteristic peak of the dV/dQ curve of the negative electrode of the lithium battery and a characteristic peak of the dV/dQ curve of the positive electrode of the lithium battery are aligned with the characteristic peak of the dV/dQ curve of the lithium battery. Corresponding OCVs of the lithium battery in different SOCs of the lithium battery and corresponding OCVs of the negative electrode of the lithium battery in different SOCs of the lithium battery are obtained based on the dV/dQ curve of the negative electrode of the lithium battery and the dV/dQ curve of the lithium battery after the characteristic peaks are aligned.

In a possible implementation of the first aspect, the correspondence between the SOH and temperature of the lithium battery and the target parameter is established and stored, so that in a subsequent lithium plating diagnosis process, the target parameter in the lithium plating estimation model of the lithium battery can be directly determined based on the SOH and temperature of the lithium battery, and the correspondence between the SOH and temperature of the lithium battery and the target parameter, to obtain a required lithium plating estimation model of the lithium battery.

According to a second aspect, an apparatus for detecting lithium plating in a lithium battery is provided, which includes: a target parameter determining unit, configured to determine, based on a state of health SOH of the lithium battery, a temperature of the lithium battery, and a correspondence between the SOH of the lithium battery and the temperature of the lithium battery and a target parameter, a target parameter corresponding to the lithium battery, where the target parameter corresponding to the lithium battery is a ratio of a polarization voltage of a negative electrode of the lithium battery to a polarization voltage of the lithium battery, and the polarization voltage is a difference between an actual voltage and an open-circuit voltage; a model determining unit, configured to substitute the target parameter corresponding to the lithium battery into a preset lithium plating estimation model, to obtain a lithium plating estimation model of the lithium battery; a diagnostic parameter obtaining unit, configured to enter a charge current of the lithium battery, a voltage of the lithium battery, the temperature of the lithium battery, and the SOH of the lithium battery into the lithium plating estimation model of the lithium battery, to obtain a real-time potential value of the negative electrode of the lithium battery; and a lithium plating diagnosis unit, configured to: determine that lithium plating occurs in the lithium battery if the real-time potential value of the negative electrode of the lithium battery is less than zero.

In a possible implementation of the second aspect, the target parameter determining unit is further configured to: charge the lithium battery at different temperatures and in different SOHs by using a preset charge rate, a first charge rate, a second charge rate, and a third charge rate; during charging of the lithium battery at the preset charge rate, determine corresponding open-circuit voltages OCVs of the lithium battery in different states of charge SOCs of the lithium battery and corresponding OCVs of the negative electrode of the lithium battery in different SOCs of the lithium battery, where the OCV of the negative electrode of the lithium battery is a reference potential of the negative electrode of the lithium battery relative to a lithium electrode; separately obtain corresponding temperatures and pressure of the lithium battery in different SOCs during charging of the lithium battery at the first charge rate, the second charge rate, or the third charge rate, where the corresponding pressure of the lithium battery in different SOCs is used to indicate a change of an external swelling volume of the lithium battery during charging; determine, based on the corresponding temperatures and pressure of the lithium battery in different SOCs, corresponding lithium plating effect pressure of the lithium battery in different SOCs, where the corresponding lithium plating effect pressure of the lithium battery in different SOCs is used to indicate a pressure change of the lithium battery caused by a lithium plating effect; determine the polarization voltage of the negative electrode of the lithium battery and the polarization voltage of the lithium battery based on the corresponding OCVs of the lithium battery in different SOCs of the lithium battery, the corresponding OCVs of the negative electrode of the lithium battery in different SOCs of the lithium battery, and the corresponding lithium plating effect pressure of the lithium battery in different SOCs; and finally establish a correspondence between the temperature of the lithium battery, the SOH of the lithium battery, and the target parameter, namely the ratio of the polarization voltage of the negative electrode of the lithium battery to the polarization voltage of the lithium battery.

In a possible implementation of the second aspect, the corresponding temperatures and pressure of the lithium battery in different SOCs include a first temperature and first pressure corresponding to the first charge rate, a second temperature and second pressure corresponding to the second charge rate, and third pressure corresponding to the third charge rate. The first pressure is total pressure caused by a lithium ion deintercalation effect, a temperature effect, and the lithium plating effect. The second pressure is total pressure caused by the lithium ion deintercalation effect and the temperature effect. The third pressure is pressure caused by the lithium ion deintercalation effect.

In a possible implementation of the second aspect, the target parameter determining unit is specifically configured to: determine an association relationship between temperature effect pressure of the lithium battery and the temperature of the lithium battery based on the second temperature and differences between the second pressure and the third pressure in different SOCs, where the temperature effect pressure of the lithium battery is used to indicate a pressure change caused by the temperature effect of the lithium battery at different temperatures; determine, based on the first temperature and the association relationship, corresponding temperature effect pressure of the lithium battery in different SOCs during charging the lithium battery at the first charge rate; and finally determine, as the corresponding lithium plating effect pressure of the lithium battery in different SOCs, differences between the first pressure and a sum of the third pressure and the corresponding temperature effect pressure of the lithium battery in different SOCs.

In a possible implementation of the second aspect, the target parameter determining unit is specifically configured to: determine, as the polarization voltage of the negative electrode, a corresponding OCV of the negative electrode of the lithium battery in a start SOC, where the start SOC is a corresponding SOC when a pressure value of the lithium plating effect pressure changes from zero to non-zero; and determine, as the polarization voltage of the lithium battery, a difference between the voltage of the lithium battery in an end SOC and a corresponding OCV of the lithium battery in the end SOC, where the end SOC is an SOC corresponding to a maximum pressure value of the lithium plating effect pressure.

In a possible implementation of the second aspect, the preset lithium plating estimation model is

$$\begin{cases} SOC = \dfrac{\int Idt}{Q} \\ V_{neg} = OCV_{neg} - V_{p,neg} = OCV_{neg}(SOC, T, SOH) - \alpha(V_{cell} - OCV_{cell}(SOC, T, SOH)) \end{cases}$$

, where I is the charge current of the lithium battery, Q is a rated capacity of the lithium battery, $\int Idt$ represents an electric capacity of the lithium battery at a current moment, SOC is the state of charge of the lithium battery, $V_{neg}$ is the real-time potential value of the negative electrode of the lithium battery, $OCV_{neg}$ is the open-circuit voltage of the negative electrode of the lithium battery, $V_{p,neg}$ is the polarization voltage of the negative electrode of the lithium battery, T is the temperature of the lithium battery, SOH is the state of health of the lithium battery, $OCV_{neg}$(SOC, T, SOH) is a function of $OCV_{neg}$ on SOC, T, and SOH, $\alpha$ is a target parameter in the lithium plating estimation model of the lithium battery, $V_{cell}$ is the voltage of the lithium battery, $OCV_{cell}$(SOC, T, SOH) is a function of $OCV_{cell}$ on SOC, T, and SOH, and $V_{cell}$ - $OCV_{cell}$(SOC, T, SOH) represents the polarization voltage of the lithium battery.

In a possible implementation of the second aspect, the apparatus further includes a lithium plating alarm unit, configured to output lithium plating alarm information. The lithium plating alarm information includes at least one of a lithium plating occurrence moment, a lithium plating end moment, an SOC corresponding to the lithium plating occurrence moment, and a lithium plating severity level. The lithium plating severity level is determined based on lithium plating duration and the real-time potential value of the negative electrode of the lithium battery.

In a possible implementation of the second aspect, the lithium plating alarm unit is configured to output lithium plating alarm information after it is determined that lithium plating occurs in the lithium battery. The lithium plating alarm information includes at least one of a lithium plating occurrence moment, a lithium plating end moment, an SOC corresponding to the lithium plating occurrence moment, and a lithium plating severity level. The lithium plating severity level is determined based on lithium plating duration and the real-time potential value of the negative electrode.

In a possible implementation of the second aspect, the apparatus further includes a current control unit. The current control unit is configured to adjust the charge current of the lithium battery based on the real-time potential value of the negative electrode of the lithium battery.

In a possible implementation of the second aspect, the apparatus further includes a current control unit. The current control unit is configured to determine a maximum safe charge current of the lithium battery based on the lithium plating occurrence moment and the SOC corresponding to the lithium plating occurrence moment.

In a possible implementation of the second aspect, the target parameter determining unit is specifically configured to: during charging of the lithium battery at a preset charge rate, obtain a correspondence between an OCV of the lithium battery and a charge capacity of the lithium battery, a correspondence between an OCV of the negative electrode of the lithium battery and a charge capacity of the negative electrode, and a correspondence between an OCV of a positive electrode of the lithium battery and a charge capacity of the positive electrode. Based on the foregoing correspondences, differential processing is performed on the voltage and the charge capacity of the lithium battery, to obtain a dV/dQ curve of the lithium battery. Similarly, a dV/dQ curve of the negative electrode of the lithium battery and a dV/dQ curve of the positive electrode of the lithium battery may be obtained. Subsequently, translation or scaling processing is performed on the dV/dQ curve of the negative electrode of the lithium battery and the dV/dQ curve of the positive electrode of the lithium battery based on a characteristic peak of the dV/dQ curve of the lithium battery, so that a characteristic peak of the dV/dQ curve of the negative electrode of the lithium battery and a characteristic peak of the dV/dQ curve of the positive electrode of the lithium battery are aligned with the characteristic peak of the dV/dQ curve of the lithium battery. Corresponding OCVs of the lithium battery in different SOCs of the lithium battery and corresponding OCVs of the negative electrode of the lithium battery in different SOCs of the lithium battery are obtained based on the dV/dQ curve of the negative electrode of the lithium battery and the dV/dQ curve of the lithium battery after the characteristic peaks are aligned.

In a possible implementation of the second aspect, the target parameter determining unit establishes and stores the correspondence between the SOH and temperature of the lithium battery and the target parameter, so that in a subsequent lithium plating diagnosis process, the target parameter in the lithium plating estimation model of the lithium battery can be directly determined based on the SOH and temperature of the lithium battery, and the correspondence between the SOH and temperature of the lithium battery and the target parameter, to obtain a required lithium plating estimation model of the lithium battery.

According to a third aspect, a device in which a lithium battery is used is provided. The device includes a lithium battery, a charge/discharge unit, the apparatus for detecting lithium plating according to any one of the second aspect or the possible implementations of the second aspect, and the like. The charge/discharge unit is configured to charge or discharge the lithium battery. The device is configured to control the charge/discharge unit and perform the method according to any one of the first aspect or the possible implementations of the first aspect.

The device in which the lithium battery is used may be a vehicle, and the vehicle may be an intelligent vehicle, an electric vehicle (electric vehicle, EV), or the like.

According to another aspect of this application, a computer-readable storage medium is provided. The computer-readable storage medium stores instructions, and when the instructions are run on a device, the device is enabled to perform the method for detecting lithium plating in a lithium battery according to any one of the first aspect or the possible implementations of the first aspect.

According to another aspect of this application, a computer program product is provided. When the computer program product runs on a device, the device is enabled to perform the method for detecting lithium plating in a lithium battery according to any one of the first aspect or the possible implementations of the first aspect.

It may be understood that any one of the apparatus, the device, the computer-readable storage medium, and the computer program product of the foregoing method for detecting lithium plating in a lithium battery is used to perform corresponding method described above. Therefore, for a beneficial effect that can be achieved by the apparatus, the device, the computer-readable storage medium, and the computer program product, refer to the beneficial effect in the corresponding method described above. Details are not described herein again.

## BRIEF DESCRIPTION OF DRAWINGS

FIG. 1 is a schematic diagram of a structure of a vehicle according to an embodiment of this application;

FIG. 2 is a schematic diagram of a structure of a battery management system according to an embodiment of this application;

FIG. 3 is a schematic flowchart of a method for detecting lithium plating in a lithium battery according to an embodiment of this application;

FIG. 4 is a schematic flowchart of another method for detecting lithium plating in a lithium battery according to an embodiment of this application;

FIG. 5(a) is a schematic diagram of correspondences between an OCV of a lithium battery and a SOC of the lithium battery, between an OCV of a positive electrode of the lithium battery and a SOC of the positive electrode of the lithium battery, and between an OCV of a negative electrode of the lithium battery and a SOC of the negative electrode of the lithium battery according to an embodiment of this application;

FIG. 5(b) is a schematic diagram of a dV/dQ curve of a lithium battery, a dV/dQ curve of a positive electrode of the lithium battery, and a dV/dQ curve of a negative electrode of the lithium battery according to an embodiment of this application;

FIG. 5(c) is a schematic diagram of adjusted correspondences between an OCV of a lithium battery and a SOC of the lithium battery, and between an OCV of a negative electrode of the lithium battery and a SOC of the negative electrode of the lithium battery according to an embodiment of this application;

FIG. 6 is a schematic diagram of a relationship between a pressure value caused by a lithium plating effect and an SOC according to an embodiment of this application;

FIG. 7(a) is a schematic diagram 1 of real-time potentials of a negative electrode of a lithium battery in different SOCs according to an embodiment of this application;

FIG. 7(b) is a schematic diagram 2 of real-time potentials of a negative electrode of a lithium battery in different SOCs according to an embodiment of this application;

FIG. 7(c) is a schematic diagram of a quantity of cyclic charging times of a lithium battery in different SOHs according to an embodiment of this application;

FIG. 8 is a schematic diagram of a measurement structure for measuring a pressure value of a lithium battery according to an embodiment of this application;

FIG. 9 is a schematic flowchart of charging and discharging a lithium battery according to an embodiment of this application; and

FIG. 10 is a schematic diagram of a structure of an apparatus for detecting lithium plating in a lithium battery according to an embodiment of this application.

## DESCRIPTION OF EMBODIMENTS

Before embodiments of this application are described, related terms in this application are first described.

A charge rate is a measure of a charge speed and is a current value required when a battery is charged to its rated capacity within a specified time. The charge rate is numerically equal to a multiple of the rated capacity of the battery, that is, charge rate = charge current/rated capacity. The charge rate is usually represented by the letter C. Here, "/" represents a division sign. For example, the rated capacity of the battery is 100 amp hours (ampere hour, Ah). If the charge current is 5 ampere (ampere, A), the charge rate is 0.05 C. If the charge current is 20 A, the charge rate is 0.2 C. If the charge current is 100 A, the charge rate is 1 C.

A discharge rate is a measure of a discharge speed and is a current value required when a battery is discharged to its rated capacity within a specified time. The discharge rate is numerically equal to a multiple of the rated capacity of the battery, that is, discharge rate = discharge current/rated capacity. The discharge rate is usually represented by the letter C. For example, the rated capacity of the battery is 100 Ah. If the discharge current is 5 A, the discharge rate is 0.05 C. If the discharge current is 20 A, the discharge rate is 0.2 C. If the discharge current is 100 A, the discharge rate is 1 C.

Coulombic efficiency (Coulombic efficiency), also known as discharge efficiency, is ratio of a discharge capacity to a charge capacity of a battery in a same cycle, that is, a percentage of the discharge capacity to the charge capacity. For a positive electrode material, Coulombic efficiency is lithium intercalation capacity/lithium deintercalation capacity, that is, discharge capacity/charge capacity. For a negative electrode material, Coulombic efficiency is lithium deintercalation capacity/lithium intercalation capacity, that is, discharge capacity/charge capacity. Herein, "/" represents a division sign.

A state of charge (state of charge, SOC) is a physical quantity used to reflect a remaining capacity status of the battery. The SOC is numerically defined as a ratio of a remaining battery capacity to a battery capacity, that is, SOC = remaining battery capacity/battery capacity. The value of the SOC ranges from 0 to 1. When the SOC is 0, the battery is completely discharged. When the SOC is 1, the battery is fully charged.

A state of health (SOH) is a physical quantity used to reflect an aging degree of the battery. The SOH is numerically defined as a ratio of a maximum available battery capacity to a rated battery capacity, that is, SOH = maximum available battery capacity/rated battery capacity. The value of SOC ranges from 0 to 1. Larger value of SOC indicates a better status of health and a lower aging degree of the battery.

A lithium battery, also called a lithium-ion battery, is a secondary battery. Usually, a lithium compound such as lithium cobalt oxide, lithium nickel oxide, or lithium manganese oxide is used as a positive electrode material of the battery, and a carbon material such as petroleum coke or graphite is used as a negative electrode material of the battery. The lithium battery works mainly through deintercalation and intercalation of lithium ions (Li+) between positive and negative electrodes. During charging, lithium ions are deintercalated from the positive electrode of the battery and enter electrolyte, and the lithium ions in the electrolyte are intercalated into the negative electrode. In a discharging process, the lithium ions intercalated into the negative electrode are deintercalated from the negative electrode and enter the electrolyte, and the lithium ions in the electrolyte are intercalated into the positive electrode of the battery.

A lithium ion deintercalation effect may refer to a characteristic that a related parameter of a lithium battery changes due to deintercalation and intercalation of lithium ions. In a process in which the lithium ions are deintercalated from a positive electrode material and intercalated into a negative electrode material, a volume of the lithium battery expands, resulting a pressure change of the lithium battery. In this application, pressure generated through deintercalation and intercalation of the lithium ions is referred to as pressure caused by the lithium ion deintercalation effect.

A temperature effect may refer to a characteristic that a related parameter of a lithium battery changes due to a temperature change of the lithium battery during charging of the lithium battery. During charging of the lithium battery, the temperature change of the lithium battery causes thermal expansion of the lithium battery, resulting in a pressure change of the lithium battery. In this application, pressure generated by the temperature change is referred to as pressure caused by the temperature effect.

Lithium plating is a process in which metal lithium forms on the surface of a negative electrode when lithium ions deintercalated from a positive electrode cannot be intercalated into the negative electrode during charging of a lithium battery.

A lithium plating effect may refer to a characteristic that a related parameter of a lithium battery changes due to lithium metal precipitated from a negative electrode during charging of the lithium battery. During charging of the lithium battery, the lithium metal precipitated from the negative electrode causes a volume change of the lithium battery. A larger amount of the precipitated lithium metal indicates a larger volume change, resulting in a pressure change of the lithium battery. In this application, pressure generated by the precipitated lithium metal is referred to as pressure caused by the lithium plating effect.

To clearly describe the technical solutions in embodiments of this application, terms such as "first" and "second" are used in embodiments of this application to distinguish between same items or similar items that provide basically same functions or purposes. For example, a first threshold and a second threshold are merely used for distinguishing between different thresholds, and a sequence thereof is not limited. A person skilled in the art may understand that the terms such as "first" and "second" do not constitute a limitation on a quantity or an execution sequence, and that the terms such as "first" and "second" do not indicate a definite difference.

It should be noted that, in this application, words such as "example" or "for example" are used for representing giving an example, an illustration, or a description. Any embodiment or design scheme described as an "example" or "for example" in this application should not be explained as being more preferred or having more advantages than another embodiment or design scheme. Exactly, use of the word such as "example" or "for example" is intended to present a related concept in a specific manner.

In this application, "at least one" means one or more, and "a plurality of" means two or more. "And/or" describes an association relationship between associated objects, and represents that three relationships may exist. For example, A and/or B may represent the following cases: Only A exists, both A and B exist, and only B exists, where A and B may be singular or plural. The character "/" generally represents an "or" relationship between the associated objects. "At least one of the following items (pieces)" or a similar expression thereof indicates any combination of these items, including a single item (piece) or any combination of a plurality of items (pieces). For example, at least one of a, b, or c may represent a combination of a, b, c, a, and b, a combination of a and c, a combination of b and c, or a combination of a, b, and c, where a, b, and c may be in a singular or plural form.

The method provided in embodiments of this application may be used to detect lithium batteries in various forms. In a feasible embodiment, the lithium battery in this application may be an aluminum-shell lithium battery, a steel-shell lithium battery, a soft pack battery, or the like. In another feasible embodiment, the lithium battery in this application may be a two-electrode battery, a three-electrode battery, or the like. In still another feasible embodiment, the lithium battery in this application may be an electrochemical cell, a battery module, a battery pack, or the like.

In addition, the method provided in embodiments of this application may be applied to various devices that use a lithium battery. The lithium battery may be used as an energy storage component or may be used as a power component in different devices. The devices may include various terminal devices such as a mobile phone, a tablet computer, a wearable device, and a vehicle-mounted terminal, may include various vehicles such as a car, a truck, a motorcycle, a bus, and an airplane, or may be used in communication devices such as a base station, a mobile station, and a satellite.

The following uses a vehicle as an example to describe a structure of a device in which the method provided in this application is used.

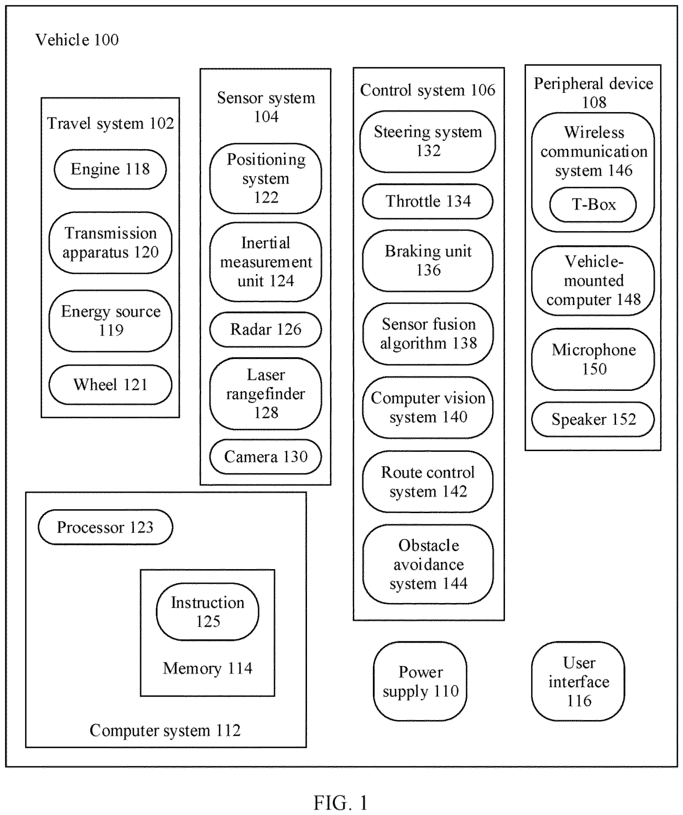

FIG. 1 is a functional block diagram of a vehicle 100 having an autonomous driving function according to an embodiment of this application. In an embodiment, the vehicle 100 is configured to be in a fully autonomous driving mode or a partially autonomous driving mode. For example, the vehicle 100 in the automatic driving mode may control a driving state of the vehicle 100. A manual operation may be performed to determine current statuses of the vehicle and an ambient environment of the vehicle, determine possible behavior of at least one another vehicle in the ambient environment, determine a possibility that the another vehicle performs the possible behavior, and control the vehicle 100 based on determined information. When the vehicle 100 is in the autonomous driving mode, the vehicle 100 may be configured to operate without interacting with a person.

Refer to FIG. 1. The vehicle 100 may include various subsystems, for example, a travel system 102, a sensor system 104, a control system 106, one or more peripheral devices 108, a power supply 110, a computer system 112, and a user interface 116. Optionally, the vehicle 100 may include more or fewer subsystems, and each subsystem may include a plurality of elements. In addition, all the subsystems and elements of the vehicle 100 may be interconnected in a wired or wireless manner.

The travel system 102 may include a component providing power to the vehicle 100 for moving. In an embodiment, the travel system 102 may include an engine 118, an energy source 119, a transmission apparatus 120, and wheels 121. The engine 118 may be an internal combustion engine, an electric motor, an air compression engine, or a combination of other types of engines, for example, a hybrid engine including a gasoline engine and an electric motor, or a hybrid engine including an internal combustion engine and an air compression engine. The engine 118 converts the energy source 119 into mechanical energy.

Examples of the energy source 119 include gasoline, diesel, other oil-based fuels, propane, other compressed gas-based fuels, ethanol, solar panels, batteries, and other power sources. The energy source 119 may also provide energy to another system of the vehicle 100.

The transmission apparatus 120 may transmit mechanical power from the engine 118 to the wheels 121. The transmission apparatus 120 may include a gearbox, a differential, and a drive shaft. In an embodiment, the transmission apparatus 120 may further include another component, for example, a clutch. The drive shaft may include one or more shafts that may be coupled to one or more wheels 121.

The sensor system 104 may include several sensors that sense information about the ambient environment of the vehicle 100. For example, the sensor system 104 may include a positioning system 122 (for example, the positioning system may be a global positioning system (global positioning system, GPS), or may be a BeiDou system or another positioning system), an inertial measurement unit (inertial measurement unit, IMU) 124, a radar 126, a laser rangefinder 128, and a camera 130. The sensor system 104 may further include a sensor (for example, an in-vehicle air quality monitor, a fuel gauge, or an engine oil thermometer) of an internal system of the monitored vehicle 100. Sensor data from one or more of these sensors can be used to detect an object and corresponding features (a position, a shape, a direction, a speed, and the like) of the object. Such detection and recognition are key functions of a safe operation of the autonomous vehicle 100. In this embodiment of this application, the sensor system 104 may be configured to measure a status parameter such as a temperature and a volume expansion pressure of a battery.

The positioning system 122 may be configured to estimate a geographic location of the vehicle 100. The IMU 124 is configured to sense a position and an orientation change of the vehicle 100 based on an inertial acceleration. In an embodiment, the IMU 124 may be a combination of an accelerometer and a gyroscope.

The radar 126 may sense an object in the ambient environment of the vehicle 100 through a radio signal. In some embodiments, in addition to sensing an object, the radar 126 may further be configured to sense a speed and/or a moving direction of the object.

The laser rangefinder 128 may sense, by using a laser, an object in an environment in which the vehicle 100 is located. In some embodiments, the laser rangefinder 128 may include one or more laser sources, a laser scanner, one or more detectors, and another system component.

The camera 130 may be configured to capture a plurality of images of the ambient environment of the vehicle 100. The camera 130 may be a static camera or a video camera.

The control system 106 controls operations of the vehicle 100 and components of the vehicle 100. The control system 106 may include various elements, including a steering system 132, a throttle 134, a braking unit 136, a sensor fusion algorithm 138, a computer vision system 140, a route control system 142, and an obstacle avoidance system 144. The obstacle avoidance system 144 may also be referred to as an obstacle avoidance system.

The steering system 132 may be operated to adjust a moving direction of the vehicle 100. For example, in an embodiment, the steering system 132 may be a steering wheel system.

The throttle 134 is configured to control an operating speed of the engine 118 and further control a speed of the vehicle 100.

The braking unit 136 is configured to control the vehicle 100 to decelerate. The braking unit 136 may use friction to slow down the wheels 121. In another embodiment, the braking unit 136 may convert kinetic energy of the wheels 121 into a current. Alternatively, the braking unit 136 may reduce a rotational speed of the wheels 121 in another form to control the speed of the vehicle 100.

The computer vision system 140 may be operated to process and analyze an image captured by the camera 130, to recognize an object and/or a feature in the ambient environment of the vehicle 100. The object and/or the feature may include a traffic signal, a road boundary, and an obstacle. The computer vision system 140 may use an object recognition algorithm, a structure from motion (structure from motion, SFM) algorithm, video tracking, and another computer vision technology. In some embodiments, the computer vision system 140 may be configured to draw a map for an environment, track an object, estimate a speed of the object, and the like.

The route control system 142 is configured to determine a driving route of the vehicle 100. In some embodiments, the route control system 142 may determine the travel route for the vehicle 100 with reference to data from the sensor fusion algorithm 138, the positioning system 122, and one or more predetermined maps.

The obstacle avoidance system 144 is configured to recognize, evaluate, and avoid or surmount, in other manners, potential obstacles in the environment of the vehicle 100.

It should be understood that the control system 106 may add or include a component as replacement other than the components shown and described. Some of the shown components may be removed from the control system 106.

The vehicle 100 interacts with an external sensor, another vehicle, another computer system, or a user by using the peripheral device 108. The peripheral device 108 may include a wireless communication system 146, a vehicle-mounted computer 148, a microphone 150, and/or a speaker 152.

In some embodiments, the peripheral device 108 provides a means for a user of the vehicle 100 to interact with the user interface 116. For example, the vehicle-mounted computer 148 may provide information to the user of the vehicle 100. The user interface 116 may further operate the vehicle-mounted computer 148 to receive an input from the user. The vehicle-mounted computer 148 may perform an operation by using a touchscreen. In another case, the peripheral device 108 may provide a means for the vehicle 100 to communicate with another device located in the vehicle. For example, the microphone 150 may receive audio (for example, a voice command or another audio input) from the user of the vehicle 100. Similarly, the speaker 152 may output audio to the user of the vehicle 100.

The wireless communication system 146 may wirelessly communicate with one or more devices directly or through a communication network. In this embodiment of this application, the wireless communication system 146 may include a telematics box (Telematics BOX, T-Box). The T-Box may be installed in a place that is inside the vehicle 100 and that is not easily touched by a human hand, for example, installed under a dash board, under a glovebox, or under a trunk. The T-Box is mainly responsible for communication between the vehicle 100 and an Internet of vehicles service platform. For example, the T-Box may use 3G cellular communication such as code division multiple access (code division multiple access, CDMA), a global system for mobile communications (global system for mobile communications, GSM), a general packet radio service (general packet radio service, GPRS) technology, or 4G cellular communication such as long term evolution (long term evolution, LTE), or 5G cellular communication. The wireless communication system 146 may communicate with a wireless local area network (wireless local area network, WLAN) through Wi-Fi. In some embodiments, the wireless communication system 146 may directly communicate with a device through an infrared link, Bluetooth, or ZigBee. Other wireless protocols, for example, various vehicle communication systems such as the wireless communication system 146, may include one or more dedicated short range communications (dedicated short range communications, DSRC) devices, which may include public and/or private data communication between vehicles and/or roadside stations.

The power supply 110 may provide power to various components of the vehicle 100. In an embodiment, the power supply 110 may be a rechargeable lithium-ion battery or a rechargeable lead-acid battery. One or more battery packs of such a battery may be configured as the power supply to supply power to the components of the vehicle 100. In some embodiments, the power supply 110 and the energy source 119 may be implemented together, for example, in some pure electric vehicles.

Some or all of functions of the vehicle 100 are controlled by the computer system 112. The computer system 112 may include at least one processor 123. The processor 123 executes instructions 125 stored in a non-transitory computer-readable medium such as a memory 114. The computer system 112 may alternatively be a plurality of computing devices that control an individual component or a subsystem of the vehicle 100 in a distributed manner.

The processor 123 may be any conventional processor, such as a commercially available central processing unit (central processing unit, CPU). Optionally, the processor may be a dedicated device, for example, an application-specific integrated circuit (application-specific integrated circuit, ASIC) or another hardware-based processor.

Although FIG. 1 functionally illustrates other elements of the processor, the memory, and the computer system 112 in a same block, a person of ordinary skill in the art should understand that the processor, the computer, or the memory may actually include a plurality of processors, computers, or memories that may or may not be stored in a same physical housing. For example, the memory may be a hard disk drive or another storage medium located in a housing different from that of the computer system 112. Therefore, a reference to the processor or the computer is understood to include a reference to a set of processors or computers or memories that may or may not operate in parallel. Different from using a single processor to perform the steps described herein, some components, such as a steering component and a deceleration component, each may include a respective processor that performs only computation related to a component-specific function.

In some embodiments, the memory 114 may include the instructions 125 (for example, program logics), and the instructions 125 may be executed by the processor 123 to perform various functions of the vehicle 100, including the functions described above. The memory 114 may also include additional instructions, including instructions used to send data to, receive data from, interact with, and/or control one or more of the travel system 102, the sensor system 104, the control system 106, and the peripheral device 108.

In addition to the instructions 125, the memory 114 may further store data, such as a road map, route information, and a location, a direction, a speed, and other such vehicle data of the vehicle, and other information. Such information may be used by the vehicle 100 and the computer system 112 when the vehicle 100 operates in an autonomous mode, a semi-autonomous mode, and/or a manual mode.

The user interface 116 is used to provide information for or receive information from the user of the vehicle 100. Optionally, the user interface 116 may include one or more input/output devices within a set of peripheral devices 108, such as the wireless communication system 146, the vehicle-mounted computer 148, the microphone 150, and the speaker 152.

The computer system 112 may control the functions of the vehicle 100 based on inputs received from various subsystems (for example, the travel system 102, the sensor system 104, and the control system 106) and from the user interface 116. For example, the computer system 112 may use an input from the control system 106 to control the steering system 132 to avoid an obstacle detected by the sensor system 104 and the obstacle avoidance system 144. In some embodiments, the computer system 112 may be operated to provide control over many aspects of the vehicle 100 and the subsystems of the vehicle 100. For example, the computer system 112 may include a battery management system (battery management system, BMS). The BMS may be configured to manage the power supply 110, and may be specifically configured to manage a lithium-ion battery. Generally, the BMS has a function of measuring a battery voltage to prevent or avoid abnormal situations such as overdischarge, overcharge, or overtemperature of the battery.

Optionally, one or more of the foregoing components may be installed separately from or associated with the vehicle 100. The components installed separately are associated with the vehicle 100. For example, the memory 114 may be partially or completely separated from the vehicle 100. The foregoing components may be communicatively coupled together in a wired and/or wireless manner. Being communicatively coupled herein means that a plurality of components coupled together may communicate with each other.

Optionally, the foregoing components are merely examples. During actual application, components in the foregoing modules may be added or removed based on an actual requirement. FIG. 1 should not be construed as a limitation on this embodiment of this application.

An autonomous vehicle traveling on a road, for example, the vehicle 100, may recognize an object in an ambient environment of the autonomous vehicle, to determine to adjust a current speed. The object may be another vehicle, a traffic control device, or another object of another type. In some examples, each recognized object may be considered independently, and based on features of each object, such as a current speed of the object, an acceleration of the object, and a spacing between the object and the vehicle, may be used to determine the speed to be adjusted by the autonomous vehicle.

Optionally, the autonomous vehicle 100 or a computing device associated with the autonomous vehicle 100 (for example, the computer system 112, the computer vision system 140, or the memory 114 in FIG. 1) may predict behavior of the identified object based on a feature of the identified object and a state of the ambient environment (for example, traffic, rain, and ice on a road). Optionally, identified objects depend on behavior of each other, and therefore all the identified objects may be considered together to predict behavior of a single identified object. The vehicle 100 can adjust the speed of the vehicle based on the predicted behavior of the identified object. In other words, the autonomous vehicle can determine, based on the predicted behavior of the object, a specific stable state (for example, acceleration, deceleration, or stop) to which the vehicle needs to be adjusted. In this process, another factor, for example, a transverse location of the vehicle 100 on a road on which the vehicle 100 moves, a curvature of the road, or proximity between static and dynamic objects, may also be considered, to determine the speed of the vehicle 100.

In addition to providing an instruction for adjusting the speed of the autonomous vehicle, the computing device may provide an instruction for modifying a steering angle of the vehicle 100, so that the autonomous vehicle can follow a given track and/or maintain a safe horizontal distance and a safe vertical distance from an object (for example, a car on a neighboring lane of the road) near the autonomous vehicle.

The vehicle 100 may be a car, a truck, a motorcycle, a bus, a boat, an airplane, a helicopter, a lawn mower, a recreational vehicle, a playground vehicle, a construction device, a trolley, a golf cart, a train, a handcart, or the like. This is not specifically limited in this embodiment of this application.

After the vehicle 100 is described, the following describes the BMS in the vehicle 100 in this application. It should be understood that embodiments of this application are applicable to a BMS of another terminal, for example, a mobile phone, a tablet computer, a camera, a computer, a netbook computer, an ultra-mobile personal computer (ultra-mobile personal computer, UMPC), a wearable device (for example, a smart band or a smartwatch), a vehicle-mounted device, or a portable device.

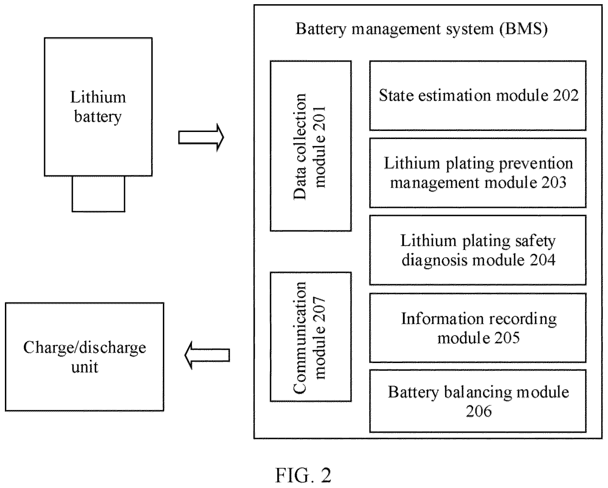

FIG. 2 is a schematic diagram of a structure of a battery management system BMS according to an embodiment of this application. The BMS may include: a data collection module 201, a state estimation module 202, a lithium plating prevention management module 203, a lithium plating safety diagnosis module 204, an information recording module 205, a battery balancing module 206, and a communication module 207.

The data collection module 201 may be configured to collect related parameter information of a lithium battery. For example, the data collection module 201 may include a voltage sensor, a current sensor, a temperature sensor, and a pressure sensor, which are respectively configured to collect parameter information such as a voltage, a current, a temperature, and pressure of the lithium battery. The state estimation module 202 may be configured to estimate a related state of the lithium battery. For example, the state estimation module 202 may be configured to estimate a remaining useful life of the lithium battery, whether the lithium battery is in a safe state, and the like. The lithium plating prevention management module 203 may be configured to manage allowable maximum charge current thresholds of the lithium battery under different charge conditions, and further control parameters such as a charge current of a charge/discharge unit based on the maximum charge current thresholds under different charge conditions. The lithium plating safety diagnosis module 204 may be configured to diagnose whether lithium plating occurs in the lithium battery, a start point and an end point at which lithium plating occurs, and the like. The information recording module 205 may be configured to record a related parameter of the lithium battery, for example, a current, a voltage, a temperature, and pressure of the lithium battery. The battery balancing module 206 may be configured to perform balancing processing on the lithium battery, for example, configured to perform balancing processing on a voltage deviation of the lithium battery, so that the voltage deviation falls within a specific range. The communication module 207 may be configured to implement communication between the BMS and another device or unit, for example, may be configured to implement communication between the BMS and the charge/discharge unit.

It should be noted that all modules in the BMS may be implemented by using hardware, software, or a combination of hardware and software. Specifically, whether a module is implemented by using hardware, software, or a combination of hardware and software depends on a specific application and a design constraint of the technical solutions. This is not specifically limited in this embodiment of this application.

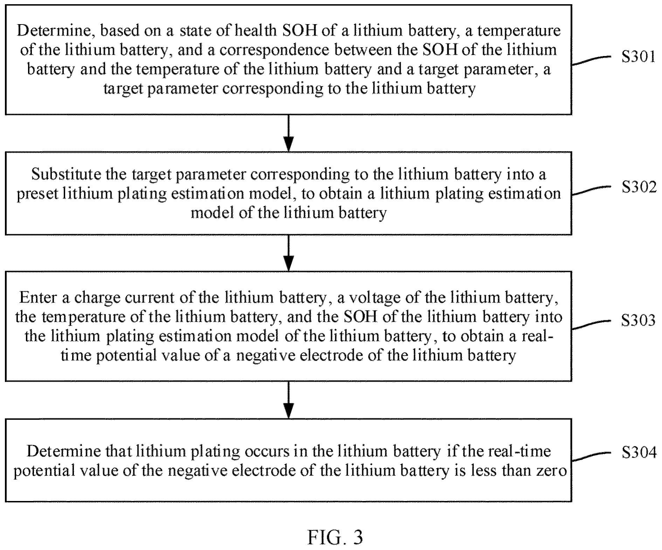

To ensure reliability of lithium plating detection of a lithium battery, an embodiment of this application provides a method for detecting lithium plating in a lithium battery. The method may be applied to various devices using the lithium battery, for example, applied to the vehicle 100 shown in FIG. 1. Specifically, the method may be performed by a BMS or a processor. The BMS and the processor may be disposed inside the vehicle 100, or may be disposed outside the vehicle 100. As shown in FIG. 3, the method includes the following steps S301 to S304.

S301: Determine, based on a state of health SOH of a lithium battery, a temperature of the lithium battery, and a correspondence between the SOH of the lithium battery and the temperature of the lithium battery and a target parameter, a target parameter corresponding to the lithium battery.

The target parameter corresponding to the lithium battery is a ratio of a polarization voltage of a negative electrode of the lithium battery to a polarization voltage of the lithium battery. The polarization voltage is a difference between an actual voltage and an open-circuit voltage. In other words, the polarization voltage of the negative electrode of the lithium battery is a difference between an actual voltage of the negative electrode of the lithium battery and an open-circuit voltage of the negative electrode of the lithium battery. The polarization voltage of the lithium battery is a difference between the actual voltage of the lithium battery and the open-circuit voltage of the lithium battery.

Optionally, there is a correspondence between the SOH of the lithium battery and the temperature of the lithium battery and the target parameter, and the correspondence may be stored in a form such as a table. Therefore, after the SOH and temperature of the lithium battery are obtained, the target parameter corresponding to the lithium battery in a current state may be determined.

For example, the correspondence between the SOH of the lithium battery and the temperature of the lithium battery and the target parameter may be shown in Table 1. The target parameters $\alpha$ corresponding to the lithium battery in different temperature ranges or different SOHs are different. If the temperature and SOH of the lithium battery meet the condition -40°C $\leq$ T < 10°C and 0.8 < SOH $\leq$ 1, the target parameter corresponding to the lithium battery is $\alpha_1$. If the temperature and SOH of the lithium battery meet the condition -10°C $\leq$ T < 20°C and 0.8 < SOH $\leq$ 1, the target parameter corresponding to the lithium battery is $\alpha_2$ If the temperature and SOH of the lithium battery meet the condition -10°C $\leq$ T < 20°C and 0.6 < SOH $\leq$ 0.8, the target parameter corresponding to the lithium battery is $\alpha_3$.

**Table 1**

| Temperature T | State of health SOH | Target parameter of lithium plating estimation model |
|---|---|---|
| -40°C $\leq$ T < 10°C | 0.8 < SOH $\leq$ 1 | $\alpha_1$ |
| -10°C $\leq$ T < 20°C | 0.8 < SOH $\leq$ 1 | $\alpha_2$ |
| -10°C $\leq$ T < 20°C | 0.6 < SOH $\leq$ 0.8 | $\alpha_3$ |

S302: Substitute the target parameter corresponding to the lithium battery into a preset lithium plating estimation model, to obtain a lithium plating estimation model of the lithium battery.

The preset lithium plating estimation model is
$$\begin{cases} SOC = \dfrac{\int I dt}{Q} \\ V_{neg} = OCV_{neg} - V_{p,neg} = OCV_{neg}(SOC,T,SOH) - \alpha(V_{cell} - OCV_{cell}(SOC,T,SOH)) \end{cases},$$
where I is a charge current of the lithium battery, Q is a rated capacity of the lithium battery, $\int Idt$ represents a capacity of the lithium battery at a current moment, SOC is the state of charge of the lithium battery, $V_{neg}$ is a real-time potential value of the negative electrode of the lithium battery, $OCV_{neg}$ is the open-circuit voltage of the negative electrode of the lithium battery, $V_{p,neg}$ is the polarization voltage of the negative electrode of the lithium battery, T is the temperature (of the lithium battery), SOH is the state of health of the lithium battery, $OCV_{neg}(SOC, T, SOH)$ is a function of $OCV_{neg}$ on SOC, T, and SOH, $\alpha$ is a target parameter in the lithium plating estimation model, $V_{cell}$ is a voltage of the lithium battery, $OCV_{cell}(SOC, T, SOH)$ is a function of $OCV_{cell}$ on SOC, T, and SOH, and $V_{cell} - OCV_{cell}(SOC, T, SOH)$ represents the polarization voltage of the lithium battery. It should be noted that, the target parameter $\alpha$ in the lithium plating estimation model is the ratio of the polarization voltage of the negative electrode of the lithium battery to the polarization voltage of the lithium battery. The SOC is obtained based on the charge current, charge time, and rated capacity of the lithium battery. $OCV_{neg}(SOC, T, SOH)$ indicates that a value of $OCV_{neg}$ may be obtained by calculating values of the SOC, T, and the SOH, querying a table, or the like. $OCV_{cell}(SOC, T, SOH)$ indicates that a value of $OCV_{cell}$ may be obtained by calculating values of the SOC, T, and the SOH, querying a table, or the like.

Table 1 is used as an example. If the temperature T of the lithium battery is 15°C and the state of health SOC of the lithium battery is 0.7, it may be determined that the target parameter corresponding to the lithium battery is $\alpha$3. The target parameter $\alpha$3 is substituted into the preset lithium plating estimation model, to obtain the lithium plating

estimation model
$$\begin{cases} SOC = \dfrac{\int I dt}{Q} \\ V_{neg} = OCV_{neg} - V_{p,neg} = OCV_{neg}(SOC,T,SOH) - \alpha_3(V_{cell} - OCV_{cell}(SOC,T,SOH)) \end{cases}$$
of the lithium battery.

S303: Enter the charge current of the lithium battery, the voltage of the lithium battery, the temperature of the lithium battery, and the SOH of the lithium battery into the lithium plating estimation model of the lithium battery, to obtain the real-time potential value of the negative electrode of the lithium battery.

The charge current of the lithium battery, the voltage of the lithium battery, the temperature of the lithium battery, and the SOH of the lithium battery are obtained as follows: The voltage of the lithium battery, the temperature of the lithium battery, and the SOH of the lithium battery are a voltage, a temperature, and a SOH of the lithium battery at a current moment. The charge current is a charge current from a start moment of charging the lithium battery to a current moment. After the lithium plating estimation model of the lithium battery is obtained in the step S302, the SOC of the lithium battery may be determined based on the charge current of the lithium battery, the charge time of the lithium

$$SOC = \frac{\int I\mathrm{dt}}{Q}$$

battery, and $SOC = \frac{\int I\mathrm{dt}}{Q}$ in the lithium plating estimation model of the lithium battery. $OCV_{neg}$ and $OCV_{cell}$ may be determined by querying a table based on the SOC, the temperature T, and the SOH of the lithium battery. Then, the real-time potential value $V_{neg}$ of the negative electrode of the lithium battery may be determined by using the lithium plating estimation model of the lithium battery based on $V_{cell}$, $OCV_{neg}$, $OCV_{cell}$, and $V_{neg} = OCV_{neg} - \alpha (V_{cell} - OCV_{cell})$.

It should be noted that, compared with a method of determining, based on a potential that is of a positive electrode or the negative electrode of the lithium battery and obtained by disassembling or modifying the battery, whether lithium plating occurs in the lithium battery, the method of this application is as follows: without damaging battery integrity, that is, without modifying or disassembling the battery, the charge current, the voltage, the temperature, and the SOH of the lithium battery that can be directly obtained are entered into the lithium plating estimation model of the lithium battery, to obtain the real-time potential of the negative electrode of the lithium battery, so as to determine, based on the real-time potential of the negative electrode of the lithium battery, whether lithium plating occurs in the lithium battery.

S304: Determine that lithium plating occurs in the lithium battery if the real-time potential value of the negative electrode of the lithium battery is less than zero.

Generally, if the real-time potential value of the negative electrode of the lithium battery is less than zero, a lithium plating condition is activated, and lithium plating occurs in the lithium battery. If the real-time potential of the negative electrode of the lithium battery is greater than zero, a lithium plating condition is deactivated, and lithium plating does not occur in the lithium battery. Therefore, if the real-time potential value that is of the negative electrode of the lithium battery and that is obtained by using the lithium plating estimation model is less than zero, it is determined that lithium plating occurs in the lithium battery. If the real-time potential value that is of the negative electrode of the lithium battery and that is obtained by using the lithium plating estimation model is greater than zero, it is determined that lithium plating does not occur in the lithium battery. If the real-time potential value that is of the negative electrode of the lithium battery and that is obtained by using the lithium plating estimation model is zero, it is considered that the lithium battery starts lithium plating or ends lithium plating.

In a possible implementation, a temperature, an SOH, a charge current, and a voltage of the lithium battery at each moment during charging are entered into the lithium plating estimation model of the lithium battery, so that a real-time potential value of the negative electrode of the lithium battery at each moment during charging of the lithium battery may be determined, to determine a lithium plating start moment, a lithium plating end moment, and a degree to which the real-time potential value of the negative electrode is less than zero in a lithium plating process. Subsequently, a lithium plating severity level of the lithium battery may be determined based on the obtained lithium plating start moment, lithium plating end moment, and degree to which the real-time potential value of the negative electrode is less than zero in the lithium plating process.

In a possible implementation, lithium plating alarm information is output after it is determined that lithium plating occurs in the lithium battery. The lithium plating alarm information includes at least one of a lithium plating occurrence moment, a lithium plating end moment, an SOC corresponding to the lithium plating occurrence moment, and a lithium plating severity level. It can be learned from the foregoing descriptions that the lithium plating severity level is determined based on lithium plating duration of the lithium battery and the real-time potential value of the negative electrode of the lithium battery.

In a possible implementation, after the real-time potential value of the negative electrode of the lithium battery is obtained, the charge current of the lithium battery may be adjusted based on the real-time potential value. For example, the charge current of the lithium battery is reduced, so that the lithium battery is away from a lithium plating state and is in a safe charging state, to ensure safety of the lithium battery during charging.

For example, if the real-time potential value of the negative electrode of the lithium battery is relatively low, for example, less than or equal to zero, or greater than zero but less than a preset potential threshold, there is a high risk of lithium plating in the lithium battery. In this case, the charge current of the lithium battery may be properly reduced, so that the lithium battery is far away from the lithium plating state, to improve the safety of the lithium battery during charging. If the real-time potential value of the negative electrode of the lithium battery is greater than zero or a preset potential threshold, the charge current of the lithium battery may be properly increased, to increase a charge rate of the lithium battery.

Because the foregoing lithium plating estimation model is used and the charge current is properly adjusted, charging safety of the lithium battery may be ensured, a charge speed of the lithium battery may be improved as much as possible, and user experience may be improved.

In a possible implementation, real-time potentials of the negative electrode of the lithium battery at different temperatures and in different SOHs and different SOCs may be obtained according to the foregoing steps, to determine, based on the real-time potential of the negative electrode of the lithium battery and a charge rate of the lithium battery, corresponding maximum charge rates of the lithium battery at different temperatures and in different SOHs and different SOCs when no lithium plating occurs in the lithium battery. Further, an allowable maximum safe charge current of the lithium battery is determined based on the maximum charge rate and a capacity of the lithium battery. Generally, the allowable maximum safe charge current of the lithium battery may be determined by performing measurement in an offline manner or in an in-vehicle environment manner. In the offline manner, the allowable maximum safe charge currents of the lithium battery determined under different conditions may be stored in the BMS as maximum safe charge current thresholds. In the in-vehicle environment, the BMS can directly measure the allowable maximum safe charge current thresholds of the lithium battery under different conditions. In this way, when controlling a charge/discharge unit to charge the lithium battery, the BMS may adjust the charge current based on the allowable maximum safe charge current thresholds of the lithium battery under different conditions, so that the charge current is always within a safe charge current range, to ensure safety of the lithium battery during charging.

In the foregoing process, information such as the charge current, SOH, SOC, temperature and the like of the lithium battery is entered into the lithium plating estimation model to obtain the real-time potential value of the negative electrode of the lithium battery, without a need to modify or disassemble the lithium battery. Then, whether lithium plating occurs in the lithium battery is determined based on the real-time potential value of the negative electrode, to simplify a process of lithium plating detection. Because lithium obtained through lithium plating is distributed on the negative electrode of the lithium battery, compared with another parameter, the real-time potential value of the negative electrode may more accurately indicate whether lithium plating occurs in the lithium battery. This ensures reliability of lithium plating detection.

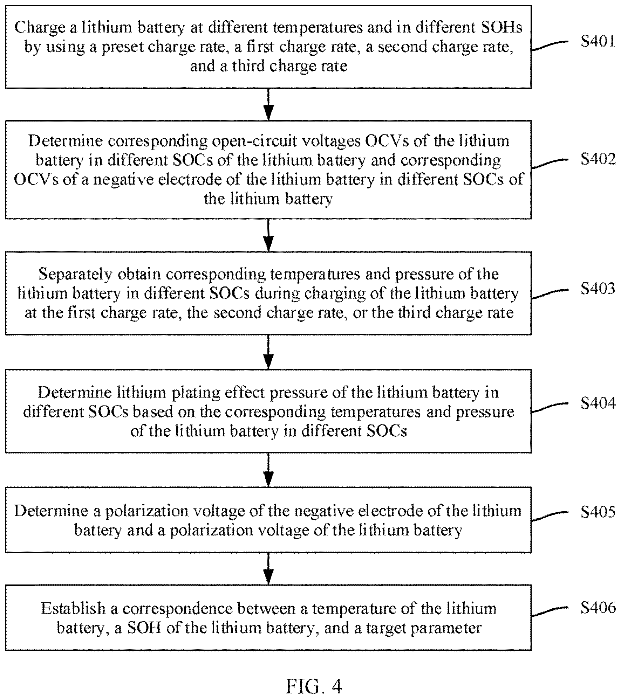

Optionally, in a possible implementation, before the step S301, this application further provides a method for detecting lithium plating in a lithium battery, to determine the correspondence between the SOH and the temperature of the lithium battery and the target parameter in the lithium plating estimation model of the lithium battery. As shown in FIG. 4, the method includes the following steps S401 to S406.

S401: Charge the lithium battery at different temperatures and in different SOHs by using a preset charge rate, a first charge rate, a second charge rate, and a third charge rate.

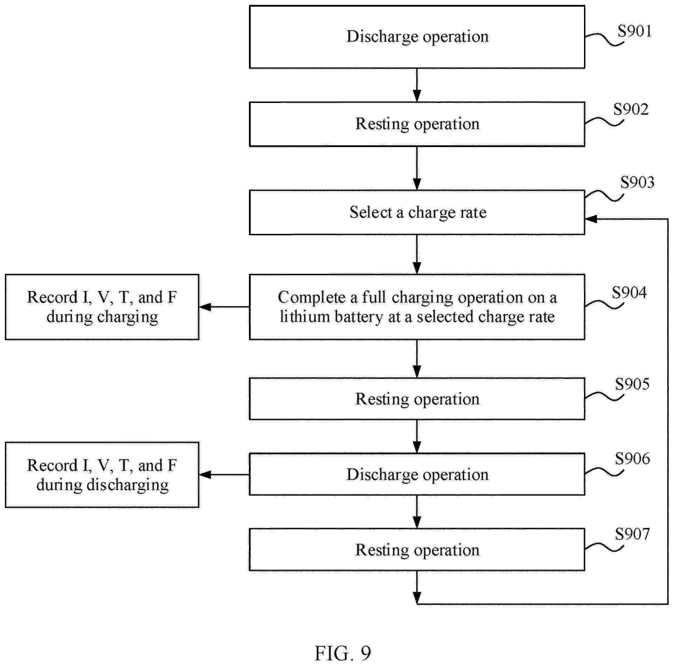

For descriptions of the preset charge rate, the first charge rate, the second charge rate, and the third charge rate, refer to the following descriptions. Details are not described herein again. For descriptions of a charging process of the lithium battery, refer to the embodiment shown in FIG. 9. Details are not described herein.

Optionally, a same lithium battery is cyclically charged first at a same temperature and in a same SOH by using the preset charge rate, the first charge rate, the second charge rate, and the third charge rate.

S402: Determine corresponding open-circuit voltages OCVs of the lithium battery in different SOCs of the lithium battery and corresponding OCVs of the negative electrode of the lithium battery in different SOCs of the lithium battery.

Optionally, corresponding open-circuit voltages OCVs of the lithium battery in different SOCs of the lithium battery and corresponding OCVs of the negative electrode of the lithium battery in different SOCs of the lithium battery are determined during charging of the lithium battery at the preset charge rate.

The OCV of the negative electrode of the lithium battery is a reference potential of an electrode formed by a negative electrode material relative to a lithium electrode. The lithium electrode is a reference electrode. The reference electrode is an electrode used as a reference comparison when measuring potentials of various electrodes. Alternatively, another suitable material may be selected for the reference electrode according to an actual application situation. In this application, an example in which the reference electrode is the lithium electrode is used to describe the technical solution.

Optionally, the lithium battery is reconstructed into a three-electrode battery, or a negative coin battery is constructed, that is, the negative coin battery is constructed by using a negative electrode material of the lithium battery as a negative electrode and using lithium as a positive electrode. The lithium battery and the negative coin battery are charged at a same preset charge rate. During charging, an open-circuit voltage and a charge capacity of each of the lithium battery and the negative coin battery are detected, to obtain a process in which the open-circuit voltage changes with the charge capacity when the two batteries are charged. Based on ratios of the charge capacities of the lithium battery and the negative coin battery to rated capacities of the two batteries, namely, the SOC of the lithium battery and a SOC of the negative coin battery, changes of the open-circuit voltages with SOCs during charging of the two batteries are determined, to determine the corresponding OCVs of the lithium battery in different states of charge SOCs of the lithium battery and the corresponding OCVs of the negative electrode of the lithium battery in different SOCs of the lithium battery. An OCV of the negative coin battery is the OCV of the negative electrode of the lithium battery.

Optionally, a correspondence between the OCV of the lithium battery and the charge capacity of the lithium battery and a correspondence between the OCV of the negative electrode of the lithium battery and the charge capacity of the lithium battery are obtained during charging of the lithium battery at the preset charge rate. A dV/dQ curve of the lithium battery and a dV/dQ curve of the negative electrode of the lithium battery are obtained based on the foregoing correspondences. Subsequently, translation or scaling processing (and/or ICA characteristic analysis) is performed on the dV/dQ curve of the negative electrode of the lithium battery based on a characteristic peak of the dV/dQ curve of the lithium battery, so that a characteristic peak of the dV/dQ curve of the negative electrode of the lithium battery is aligned with the characteristic peak of the dV/dQ curve of the lithium battery. The corresponding OCVs of the lithium battery in different SOCs of the lithium battery and the corresponding OCVs of the negative electrode of lithium battery in different SOCs are obtained based on the dV/dQ curve of the negative electrode of the lithium battery and the dV/dQ curve of the lithium battery after the characteristic peaks are aligned.

Similarly, a positive coin battery may be constructed by using a positive electrode of the lithium battery as a positive electrode and using lithium as a negative electrode. During charging of the positive coin battery at the preset charge rate, an open-circuit voltage and a charge capacity of the positive coin battery are detected, to obtain a process in which the open-circuit voltage of the positive coin battery changes with the charge capacity of the positive coin battery during charging. Corresponding OCVs of the positive electrode of the lithium battery in different SOCs are determined based on a ratio of the charge capacity of the positive coin battery to a rated capacity of the positive coin battery. The OCV of the positive coin battery is the OCV of the positive electrode of the lithium battery. Subsequently, a dV/dQ curve of the positive electrode of the lithium battery may be obtained based on a correspondence between the OCV of the positive electrode of the lithium battery and a charge capacity of the positive electrode. Translation or scaling processing is performed on the dV/dQ curve of the positive electrode of the lithium battery based on the characteristic peak of the dV/dQ curve of the lithium battery, so that a characteristic peak of the dV/dQ curve of the positive electrode of the lithium battery is aligned with the characteristic peak of the dV/dQ curve of the lithium battery.

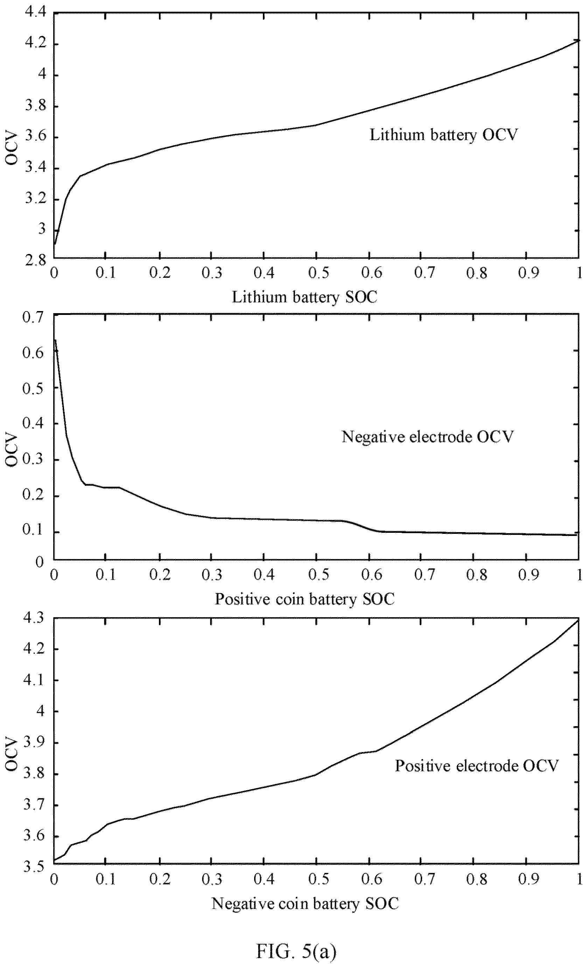

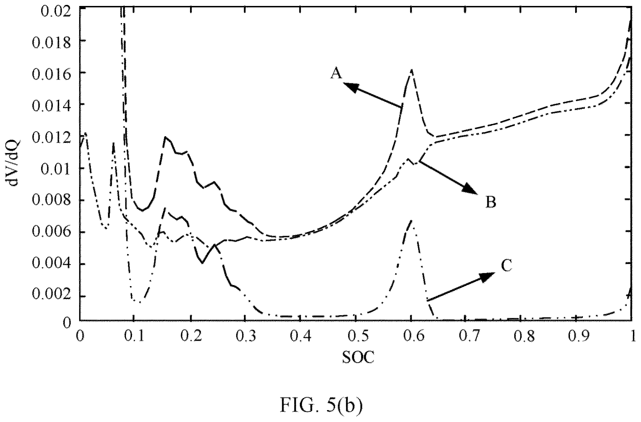

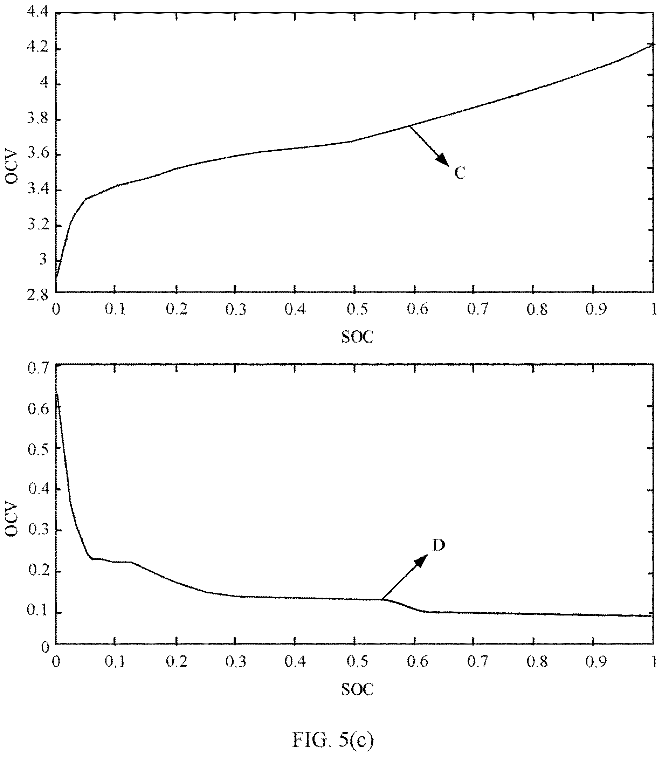

For example, the lithium battery, the negative coin battery, and the positive coin battery are charged at a charge rate of 1/20 C, to obtain a correspondence between an OCV of the lithium battery and the charge capacity of the lithium battery, a correspondence between the OCV of the negative electrode of the lithium battery (namely, the OCV of the negative coin battery) and the charge capacity of the negative coin battery, and a correspondence between the OCV of the positive electrode of the lithium battery (namely, the OCV of the positive coin battery) and the charge capacity of the positive coin battery. FIG. 5(a) separately shows the three correspondences. In FIG. 5(a), the horizontal coordinates are respectively the SOC of the lithium battery, a SOC of the positive coin battery, and the SOC of the negative coin battery (or the horizontal coordinates may alternatively be the charge capacity of the lithium battery, the charge capacity of the positive coin battery, and the charge capacity of the negative coin battery), the vertical coordinates are respectively the OCV of the lithium battery, the OCV of the positive electrode of the lithium battery, or the OCV of the negative electrode of the lithium battery. Differential analysis is performed based on the correspondences shown in FIG. 5(a), to separately obtain the dV/dQ curve of the lithium battery, the dV/dQ curve of the positive electrode of the lithium battery, and the dV/dQ curve of the negative electrode of the lithium battery. Translation or scaling processing is performed on the dV/dQ curve of the positive electrode of the lithium battery and the dV/dQ curve of the negative electrode of the lithium battery by using the dV/dQ curve of the lithium battery as a reference, so that the characteristic peak of the dV/dQ curve of the positive electrode of the lithium battery and the characteristic peak of the dV/dQ curve of the negative electrode of the lithium battery are aligned with the characteristic peak of the dV/dQ curve of the lithium battery. The characteristic peaks aligned with each other represent the same physical meaning. In FIG. 5(b), A, B, and C respectively show the dV/dQ curve of the lithium battery, the dV/dQ curve of the positive electrode of the lithium battery, and the dV/dQ curve of the negative electrode of the lithium battery. The three dV/dQ curves are obtained by aligning their characteristic peaks. Horizontal coordinates of coordinates in which A, B, and C are located are the SOC, and vertical coordinates are respectively a dV/dQ value of the lithium battery, a dV/dQ value of the positive electrode of the lithium battery, and a dV/dQ value of the negative electrode of the lithium battery. Subsequently, curves C and D shown in FIG. 5(c) may be obtained according to FIG. 5(b). C represents the corresponding OCVs of the lithium battery in different SOCs of the lithium battery, and D represents the corresponding OCVs of the negative electrode of the lithium battery in different SOCs.

In a possible implementation, the charge capacity of the lithium battery is obtained through calculation based on a charge current of the lithium battery from a charge start time to a current moment.

It should be noted that the preset charge rate is a relatively small charge rate, and charging the lithium battery at the relatively small charge rate can avoid a polarization effect of the lithium battery. For example, the preset charge rate may be 1/20 C or the like. In addition, when the positive coin battery and the negative coin battery are constructed, the lithium battery may be disassembled after a positive active material and a negative active material of the lithium battery are in a relatively safe state by completely discharging and resting the lithium battery. Then, electrolyte the same as that in the lithium battery, the lithium electrode, and the negative active material and the positive active material obtained by disassembling the lithium battery are selected to construct the needed positive coin battery and negative coin battery. Assembly of the coin battery and disassembly of the lithium battery are carried out in a glovebox.

S403: Separately obtain corresponding temperatures and pressure of the lithium battery in different SOCs during charging of the lithium battery at the first charge rate, the second charge rate, or the third charge rate.

The corresponding pressure of the lithium battery in different SOCs is used to indicate a change of an external swelling volume of the lithium battery during charging.

During charging of the lithium battery at different charge rates, related state parameters such as a temperature and pressure of the lithium battery change differently. In addition, pressure changes of the lithium battery at different charge rates may be caused by one or more of lithium ion deintercalation effect pressure, temperature effect pressure, or lithium plating effect pressure. Therefore, in a possible implementation, pressure, a temperature, and the like of the lithium battery are detected during charging of the lithium battery at each of the first charge rate, the second charge rate, and the third charge rate, to correspondingly obtain three groups of temperatures and pressure at the three charge rates. That is, the corresponding temperatures and pressure of the lithium battery in different SOCs include a first temperature and first pressure, a second temperature and second pressure, and (a third temperature and) third pressure. At the first charge rate, corresponding temperatures and pressure of the lithium battery in different SOCs are the first temperature and the first pressure. The first pressure is total pressure caused by a lithium ion deintercalation effect, a temperature effect, and a lithium plating effect. At the second charge rate, corresponding temperatures and pressure of the lithium battery in different SOCs are the second temperature and the second pressure. The second pressure is total pressure caused by the lithium ion deintercalation effect and the temperature effect. At the third charge rate, corresponding temperatures and pressure of the lithium battery in different SOCs are respectively the third temperature and the third pressure. The third pressure is pressure caused by the lithium ion deintercalation effect.

In a possible implementation, the lithium battery may be cyclically charged separately at three groups of charge rates. Each group of charge rates may include at least one charge rate, and the at least one charge rate belongs to a same charge rate, namely, the first charge rate, the second charge rate, or the third charge rate. Optionally, the three groups of charge rates include a first group of charge rates, a second group of charge rates, and a third group of charge rates. A charge rate in the first group of charge rates belongs to the first charge rate. A charge rate in the second group of charge rates belongs to the second charge rate. A charge rate in the third group of charge rates belongs to the third charge rate.

In other words, the first charge rate is a charge rate at which lithium ion deintercalation effect, the temperature effect, and the lithium plating effect occurs in the lithium battery; the second charge rate is a charge rate at which only the lithium ion deintercalation effect and the temperature effect occur in the lithium battery; and the third charge rate is a charge rate at which only the lithium ion deintercalation effect occurs in the lithium battery. Generally, when other conditions are the same, a larger charge rate indicates a greater possibility of lithium plating in the lithium battery. If the first charge rate, the second charge rate, and the third charge rate are respectively corresponding to different charge speeds, the first charge rate is greater than the second charge rate, and the second charge rate is greater than the third charge rate. For specific understanding of each effect and pressure caused by the effect, refer to the foregoing content.

For example, a value range of the first charge rate is [a1, b1], a value range of the second charge rate is [a2, b2], and a value range of the third charge rate is [a3, b3], where [a1, b1] is greater than [a2, b2], and [a2, b2] is greater than [a3, b3]. For example, [a1, b1] is equal to [3 C, 5 C], [a2, b2] is equal to [0.5 C, 2 C], and [a3, b3] is equal to [0.05 C, 0.2 C]. In addition, for lithium batteries of different specifications or different states, value ranges of the foregoing charge rates may be different.

In actual application, when the lithium battery is charged at three different groups of charge rates, a plurality of groups of pressure and temperatures may be correspondingly detected at each group of charge rates. For example, pressure and a temperature that are corresponding to a smallest charge rate in each group of charge rates are selected as pressure and a temperature that are corresponding to the group of charge rates, or a plurality of groups of pressure and temperatures that are correspondingly detected at each group of charge rates are averaged, to obtain a group of pressure and temperatures, or a group of pressure and temperatures are determined in a mathematical combination manner from a plurality of groups of pressure and temperatures that are correspondingly detected at each group of charge rates. This is not specifically limited in this embodiment of this application.

The following describes the pressure changes of the lithium battery at different charge rates. Specifically, when the lithium battery is charged at the third charge rate, the temperature of the lithium battery does not change greatly, and no lithium plating phenomenon occurs. In this case, it may be considered that the lithium ion deintercalation effect occurs during charging of the lithium battery, but the temperature effect and the lithium plating effect do not occur. In other words, the pressure change of the lithium battery is caused by the lithium ion deintercalation effect, that is, the pressure of the lithium battery is the lithium ion deintercalation effect pressure. The lithium ion deintercalation effect pressure may be a function of the SOC of the lithium battery. When the lithium battery is charged at the second charge rate, the temperature of the lithium battery changes significantly, but no lithium plating phenomenon occurs. In this case, it can be considered that the lithium ion deintercalation effect and the temperature effect occur during charging of the lithium battery, but no lithium plating effect occurs. Therefore, the pressure change of the lithium battery is caused by the lithium ion deintercalation effect and the temperature effect, that is, the pressure of the lithium battery is a sum of the lithium ion deintercalation effect pressure and the temperature effect pressure. The temperature effect pressure may be a function of the temperature of the lithium battery. When the lithium battery is charged at the first charge rate, the temperature of the lithium battery changes significantly, and a lithium plating phenomenon may occur. In this case, it may be considered that the lithium ion deintercalation effect, the temperature effect, and the lithium plating effect occur during charging of the lithium battery. Therefore, the pressure change of the lithium battery is caused by the lithium ion deintercalation effect, the temperature effect, and the lithium plating effect, that is, the pressure of the lithium battery is a sum of the lithium ion deintercalation effect pressure, the temperature effect pressure, and the lithium plating effect pressure.

Table 2 shows correspondences between the pressure of the lithium battery and the lithium ion deintercalation effect pressure, between the pressure of the lithium battery and the temperature effect pressure, and between the pressure of the lithium battery and the lithium plating effect pressure at different charge times of the lithium battery. In Table 2, charge rates include the first charge rate, the second charge rate, the third charge rate, and the like. The pressure (namely, the first pressure) of the lithium battery at the first charge rate is equal to a sum of pressure caused by the lithium ion deintercalation effect, pressure caused by the temperature effect, and pressure caused by the lithium plating effect. The pressure (namely, the second pressure) of the lithium battery at the second charge rate is equal to a sum of pressure caused by the lithium ion deintercalation effect and pressure caused by the temperature effect. The pressure (namely, the third pressure) of the lithium battery at the third charge rate is equal to pressure caused by the lithium ion deintercalation effect.

**Table 2**

| Charge rate | Pressure of lithium battery | | |
| --- | --- | --- | --- |
| | Lithium ion deintercalation effect pressure | Temperature effect pressure | Lithium plating effect pressure |
| First charge rate | √ | √ | √ |
| Second charge rate | √ | √ | × |
| Third charge rate | √ | × | × |

It should be noted that the first charge rate, the second charge rate, and the third charge rate corresponding to lithium batteries of different specifications or different forms may be the same or different. This is not specifically limited in this embodiment of this application. The first charge rate, the second charge rate, and the third charge rate may be set in advance by a person skilled in the art according to a detected specification or form of the lithium battery. For example, the third charge rate may include 0.05 C, 0.1 C, 0.2 C, and the like. The second charge rate may include 0.5 C, 1 C, 2 C, and the like. The first charge rate may include 3 C, 4 C, 5 C, and the like.

In a possible implementation, when the temperature and pressure of the lithium battery are obtained, the charge current of the lithium battery further needs to be obtained. The temperature of the lithium battery may be measured by using a temperature sensor. The pressure of the lithium battery may be measured by using a pressure sensor. The charge current of the lithium battery may be measured by using a current sensor. Integral processing is performed on the measured charge current of the lithium battery, so that corresponding SOCs of the lithium battery at different temperatures and pressure can be determined, to obtain the corresponding temperatures and pressure of the lithium battery at different SOCs.

In a possible implementation, the lithium battery is cyclically charged at the first charge rate, and an average value of corresponding data (for example, the temperature and the pressure) detected during charging at the first charge rate is used as corresponding data of the lithium battery in different SOCs when the lithium battery is charged at the first charge rate. Similarly, an average value of corresponding data detected during charging at the second charge rate is used as corresponding data of the lithium battery in different SOCs when the lithium battery is charged at the second charge rate. An average value of corresponding data detected during charging at the third charge rate is used as corresponding data of the lithium battery in different SOCs when the lithium battery is charged at the third charge rate. In the foregoing process, accidental data during charging is avoided, and reliability of detected data of the lithium battery is improved.

S404: Determine the lithium plating effect pressure of the lithium battery in different SOCs based on the corresponding temperatures and pressure of the lithium battery in different SOCs.

The lithium plating effect pressure of the lithium battery is used to indicate a pressure change of the lithium battery caused by the lithium plating effect. For specific description of the lithium plating effect pressure, refer to the foregoing content.

Optionally, an association relationship between the temperature effect pressure and the temperature of the lithium battery is determined based on the second temperature and a difference between the second pressure and the third pressure at different temperatures. The temperature effect pressure is used to indicate a pressure change caused by the temperature effect of the lithium battery at different temperatures. Subsequently, during charging of the lithium battery at the first charge rate, corresponding temperature effect pressure of the lithium battery in different SOCs of the lithium battery is determined based on the first temperature and the association relationship between the temperature effect pressure and the temperature. Finally, a difference between the first pressure and a sum of the temperature effect pressure of the lithium battery and the third pressure is determined as the corresponding lithium plating effect pressure of the lithium battery in different SOCs.

In a possible implementation, during charging of the lithium battery at the first charge rate, the corresponding first temperatures and first pressure in different SOCs may be expressed as $\{(T_{11}, F_{11}), (T_{12}, F_{12}), ..., (T_{1n}, F_{1n})\}$. Similarly, during charging of the lithium battery at the second charge rate, the corresponding second temperatures and second pressure in different SOCs may be expressed as $\{(T_{21}, F_{21}), (T_{22}, F_{22}), ..., (T_{2n}, F_{2n})\}$. During charging of the lithium battery at the third charge rate, the corresponding third temperatures and third pressure in different SOCs may be expressed as $\{(T_{31}, F_{31}), (T_{32}, F_{32}), ..., (T_{3n}, F_{3n})\}$. T is the temperature of the lithium battery, and F is the pressure.

In a possible implementation, because the charge current of the lithium battery is integrated, the charge capacity of the lithium battery can be obtained, to obtain the SOC of the lithium battery. Therefore, to some extent, the corresponding first temperatures and first pressure in different SOCs may be expressed as $\{(I_{11}, Tn, Fn), (I_{12}, T_{12}, F_{12}), ..., (I_{1n}, T_{1n}, F_{1n})\}$. I is the charge current of the lithium battery, and may be used to represent a corresponding SOC of the lithium battery at the first temperature and the first pressure. V indicates voltages of the lithium battery in different SOCs. Similarly, during charging of the lithium battery at the second charge rate, the corresponding second temperatures and second pressure in different SOCs may be expressed as $\{(I_{21}, T_{21}, F_{21}), (I_{22}, T_{22}, F_{22}), ..., and (I_{2n}, T_{2n}, F_{2n})\}$. During charging of the lithium battery at the third charge rate, the corresponding third temperatures and third pressure in different SOCs may be expressed as $\{(I_{31}, T_{31}, F_{31}), (I_{32}, T_{32}, F_{32}), ..., and (I_{3n}, T_{3n}, F_{3n})\}$.

In a possible implementation, during charging of the lithium battery, information such as charge currents, pressure, voltages, and temperatures of the lithium battery in different SOCs is obtained by using a pressure sensor, a current sensor, a temperature sensor, a voltage sensor, and the like. In this case, related information of the lithium battery in different SOCs and at the first charge rate may be expressed as $\{(I_{11}, Vn, T_{11}, Fn), (I_{12}, V_{12}, T_{12}, F_{12}), ..., (I_{1n}, V_{1n}, T_{1n}, F_{1n})\}$. Similarly, related information of the lithium battery in different SOCs and at the second charge rate may be expressed as $\{(I_{21}, V_{21}, T_{21}, F_{21}), (I_{22}, V_{22}, T_{22}, F_{22}), ..., and (I_{2n}, V_{2n}, T_{2n}, F_{2n})\}$. Related information of the lithium battery in different SOCs and at the third charge rate may be expressed as $\{(I_{31}, V_{31}, T_{31}, F_{31}), (I_{32}, V_{32}, T_{32}, F_{32}), ..., (I_{3n}, V_{3n}, T_{3n}, F_{3n})\}$, I is the charge current of the lithium battery, V is the charge voltage of the lithium battery, T is the temperature of the lithium battery, and F is the pressure of the lithium battery.

For example, the related information of the lithium battery at the second charge rate is expressed as $D2 = \{(I_{21}, V_{21}, T_{21}, F_{21}), (I_{22}, V_{22}, T_{22}, F_{22}), ..., and (I_{2n}, V_{2n}, T_{2n}, F_{2n})\}$, the related information of the lithium battery at the third charge rate is expressed as $D3 = \{(I_{31}, V_{31}, T_{31}, F_{31}), (I_{32}, V_{32}, T_{32}, F_{32}), ..., (I_{3n}, V_{3n}, T_{3n}, F_{3n})\}$. $T_{21} = T_{31}$ and $T_{31} = T_{32} = ... = T_{3n}$. Data processing is performed on D2 and D3 to obtain $D_{21} = \{(SOC_{21}, \Delta T_{21}, F_{21}), (SOC_{22}, \Delta T_{22}, F_{22}), ..., (SOC_{2n}, \Delta T_{2n}, F_{2n})\}$, $D31 = \{(SOC_{31}, F_{31}), (SOC_{32}, F_{32}), ..., (SOC_{3n}, F_{3n})\}$. $SOC_{21} = SOC_{31}$, $SOC_{22} = SOC_{32}$, ..., and $SOC_{2n} = SOC_{3n}$. $F_{3i}$ is corresponding lithium ion deintercalation effect pressure in different SOCs and at the third charge rate, and $F_{2i}$ is a sum of corresponding lithium ion deintercalation effect pressure and temperature effect pressure in different SOCs and at the second charge rate. Based on a correspondence between $SOC_{3i}$ and the pressure value $F_{3i}$ in $D_{31}$, lithium ion deintercalation effect pressure in D21 may be determined. Herein, the lithium ion deintercalation effect pressure is expressed as $D_{22} = \{(SOC_{21}, \Delta T_{21}, F'_{21}), (SOC_{22}, \Delta T_{22}, F'_{22}), ..., (SOC_{2n}, \Delta T_{2n}, F'_{2n})\}$, $F'_{2i} = F_{3i}$ It may be determined according to D21 and D22 that temperature effect pressure at the second charge rate is $D_{23} = \{(SOC_{21}, \Delta T_{21}, F_{21} - F'_{21}), (SOC_{22}, \Delta T_{22}, F_{22} - F'_{22}), ..., (SOC_{2n}, \Delta T_{2n}, F_{2n} - F'_{2n})\}$. $\Delta T_{2i} = T_{2i} - T_{21}$, where a value range of i is 1 to n (n is a positive integer). In this way, a correspondence between the temperature effect pressure and the temperature may be obtained.

Further, related information of the lithium battery at the first charge rate is expressed as $D_1 = (In, Vn, T_{11}, Fn), (I_{12}, V_{12}, T_{12}, F_{12}), ..., and (I_{1n}, V_{1n}, T_{1n}, F_{1n})$. Data processing is performed on $D_1$, to obtain $D_{11} = \{(SOC_{11}, \Delta T_{11}, Fn), (SOC_{12}, \Delta T_{12}, F_{12}), ..., (SOC_{1n}, \Delta T_{1n}, F_{1n})\}$. $\Delta T_{1i} = T_{1i} - Tn$. Lithium ion deintercalation effect pressure in D11 may be determined based on a correspondence between $SOC_{3i}$ and the pressure value $F_{3i}$ in the lithium ion deintercalation effect pressure $D_{31}$ at the third charge rate. Herein, $D_{12} = \{(SOC_{11}, \Delta T11, F'_{11}), (SOC_{12}, \Delta T_{12}, F'_{12}), ..., (SOC_{1n}, \Delta T_{1n}, F'_{1n})\}$. Temperature effect pressure in D11 may be determined based on a correspondence between $\Delta T_{2i}$ and the pressure value $F_{2i}$ in the temperature effect pressure D23 at the second charge rate. Herein, the temperature effect pressure is expressed as $D13 = \{(SOC_{11}, \Delta T_{11}, F''_{11}), (SOC_{12}, \Delta T_{12}, F''_{12}), ..., (SOC_{1n}, \Delta T_{1n}, F''_{1n})\}$. $F_{1i}$ is a sum of the lithium ion deintercalation effect pressure $F'_{1i}$, the temperature effect pressure $F''_{1i}$, and the lithium plating effect pressure at the first charge rate. The lithium plating effect pressure may be obtained according to D 11, D 12, and D13. Herein, $D14 = \{(SOC_{11}, \Delta T_{11}, F_{11} - F'_{11} - F''_{11}), (SOC_{12}, \Delta T_{12}, F_{12} - F'_{12} - F''_{12}), ..., (SOC_{1n}, \Delta T_{1n}, F_{1n} - F'_{1n} - F''_{1n})\}$. $\Delta T_{3i} = T_{3i} - T_{31}$, where a value range of i is 1 to n.

In a possible implementation, the lithium battery is discharged at a specific discharge rate. In addition, information such as a current, pressure, a voltage, and a temperature of the lithium battery may be detected in a discharging process, to determine lithium plating effect pressure of the lithium battery in different SOCs in a manner similar to the foregoing.

S405: Determine the polarization voltage of the negative electrode of the lithium battery and the polarization voltage of the lithium battery.

Optionally, the polarization voltage of the negative electrode of the lithium battery and the polarization voltage of the lithium battery are determined based on the corresponding OCVs of the lithium battery in different SOCs of the lithium battery, the corresponding OCVs of the negative electrode of the lithium battery in different SOCs of the lithium battery, and the corresponding lithium plating effect pressure of the lithium battery in different SOCs.

After the lithium plating effect pressure is determined, lithium plating in the lithium battery may be detected based on a change of a pressure value in the lithium plating effect pressure. Specifically, the lithium plating effect pressure includes pressure values at a plurality of different SOCs. Because the lithium plating effect pressure is caused by the lithium plating effect, a start SOC in which lithium plating occurs in the lithium battery and an end SOC in which lithium plating ends may be determined based on changes of the lithium plating effect pressure values in different SOCs. When the pressure value in the lithium plating effect pressure is zero or close to zero, it may be determined that lithium plating does not occur in the lithium battery. When the pressure value in the lithium plating effect pressure rises from zero to non-zero and is still in an ascending trend, it may be determined that lithium plating occurs in the lithium battery, that is, a corresponding SOC when the pressure value in the lithium plating effect pressure changes from zero to non-zero may be determined as the start SOC in which lithium plating occurs in the lithium battery. When the pressure value in the lithium plating effect pressure rises to a maximum value and starts to gradually decrease, it may be determined that lithium plating ends in the lithium battery, that is, a corresponding SOC of a maximum pressure value in the lithium plating effect pressure may be determined as the end SOC in which lithium plating ends in the lithium battery.

In addition, at a start moment of lithium plating in the lithium battery, a voltage value of the negative electrode of the lithium battery is zero. In other words, a difference between a corresponding OCV of the negative electrode in the start SOC to the polarization voltage of the negative electrode is zero. Therefore, the corresponding OCV of the negative electrode of the lithium battery in the start SOC may be determined as the polarization voltage of the negative electrode. In addition, at an end moment of lithium plating in the lithium battery, the polarization voltage of the lithium battery is a difference between a corresponding voltage of the lithium battery in the end SOC and a corresponding OCV of the lithium battery in the end SOC.

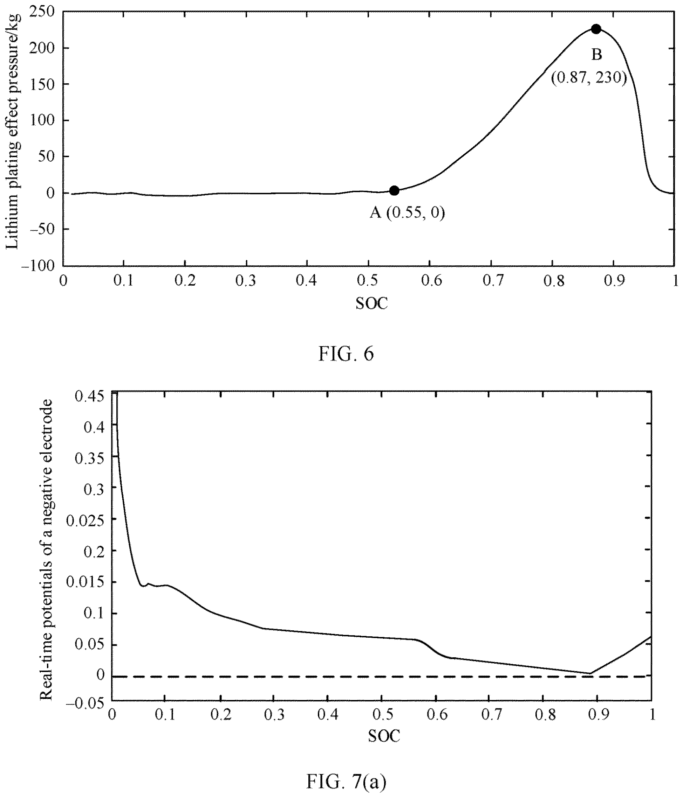

For example, a correspondence between different SOCs and pressure values in the lithium plating effect pressure shown in FIG. 6 is used as an example. When the SOC is in a range of 0 to 0.55, the pressure value is equal to 0 or close to zero. When the SOC is in the range of 0.55 to 0.87, the pressure value rises from zero to non-zero and is in an ascending trend. When the SOC is 0.87, a maximum pressure value is obtained. When the SOC is in the range of 0.87 to 1, the pressure value is in a descending trend. In FIG. 6, a point A represents a transition point at which the pressure value in the lithium plating effect pressure changes from zero to non-zero and is still in an ascending trend, and a point B represents a peak point corresponding to the maximum pressure value in the lithium plating effect pressure. The point A (0.55, 0) may be referred to as a start point of lithium plating, and SOC = 0.55 indicates a state of charge at the start of lithium plating in the lithium battery (namely, the start SOC in which lithium plating occurs). The point B (0.87, 230) may be referred to as an end point of lithium plating, and SOC = 0.87 indicates a state of charge at the end of lithium plating in the lithium battery (namely, the end SOC in which lithium plating ends).

Alternatively, in another possible implementation, when a plurality of consecutive pressure values in the lithium plating effect pressure values are greater than 0, it may be determined that lithium plating occurs in the lithium battery. Then, the corresponding SOC when the pressure value in the lithium plating effect pressure changes from zero to non-zero is determined as the start SOC in which lithium plating occurs in the lithium battery.

S406: Establish a correspondence between the temperature of the lithium battery, the SOH of the lithium battery, and the target parameter.

Optionally, after a same lithium battery is cyclically charged at a same temperature and a same SOH by using the preset charge rate, the first charge rate, the second charge rate, and the third charge rate, the steps S402 and S405 are performed. The correspondence between the temperature of the lithium battery, the SOH of the lithium battery, and the target parameter may be established after a corresponding polarization voltage of the negative electrode of the lithium battery and a corresponding polarization voltage of the lithium battery at the temperature and in the SOH are determined in step S405. The target parameter is a ratio of the polarization voltage of the negative electrode of the lithium battery to the polarization voltage of the lithium battery, of which the two polarization voltages are obtained in step S405. Subsequently, in a similar process, a correspondence between another temperature of the lithium battery, the SOH of the lithium battery, and the target parameter may be established, or a correspondence between different temperatures of the lithium battery, different SOHs of the lithium battery, and the target parameter may be established. The correspondence may be stored in a form of a table, as shown in Table 1.

For example, it is determined in the foregoing steps that the polarization voltage of the negative electrode of the lithium battery is 86.1 mV, and the polarization voltage of the lithium battery is 212.7 V It may be determined that a ratio $\alpha$ of the polarization voltage of the negative electrode of the lithium battery to the polarization voltage of the lithium battery is 0.4048.

It should be noted that the ratio of the polarization voltage of the negative electrode of the lithium battery to the polarization voltage of the lithium battery, namely, the target parameter, may not change with the SOC, the charge rate, or the like, but change with the SOH and temperature of the lithium battery. That is, there is a correspondence between the ratio and the SOH and temperature of the lithium battery.

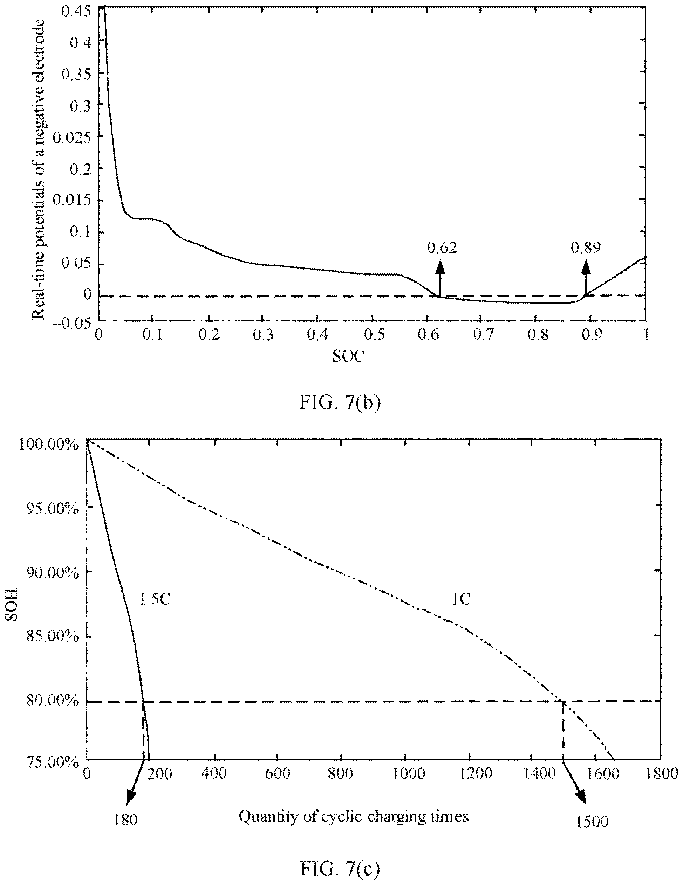

For example, after the lithium plating estimation model of the lithium battery is determined at a specific temperature and in a specific SOH, the lithium battery is separately charged at charge rates of 1 C and 1.5 C, to obtain a charge current and a voltage of the lithium battery during charging. The charge current, voltage, temperature, and SOH are entered into the determined lithium plating estimation model of the lithium battery, to obtain real-time potentials of the negative electrode of the lithium battery in different SOCs, as shown in FIG. 7(a) and FIG. 7(b). As shown in FIG. 7(a) and FIG. 7(b), during charging of the lithium battery at the charge rate of 1 C, the real-time potential of the negative electrode of the lithium battery is always greater than zero. It may be determined that no lithium plating occurs in the lithium battery. During charging of the lithium battery at the charge rate of 1.5 C, when the SOC of the lithium battery is 0.62 to 0.89, the real-time potential of the negative electrode of the lithium battery is less than zero, that is, lithium plating occurs in the lithium battery when the SOC is 0.62 to 0.89. The lithium battery is cyclically charged in different SOHs and at the charge rates of 1 C and 1.5 C, to obtain a quantity of times that the lithium battery may be cyclically charged in different SOHs. As shown in FIG. 7(c), when the SOH of the lithium battery is 80.00%, a process of charging the lithium battery at 1.5 C may be cycled for 180 times, and a process of charging the lithium battery at 1 C may be cycled for 1500 times. 180 times is far less than 1500 times. Therefore, FIG. 7(c) may indirectly reflect that lithium plating probably occurs in the lithium battery during charging of the lithium battery at 1.5 C. In conclusion, it may be determined according to FIG. 7(a), FIG. 7(b), and FIG. 7(c) that whether lithium plating occurs in the lithium battery during charging may be relatively accurately determined in this application.

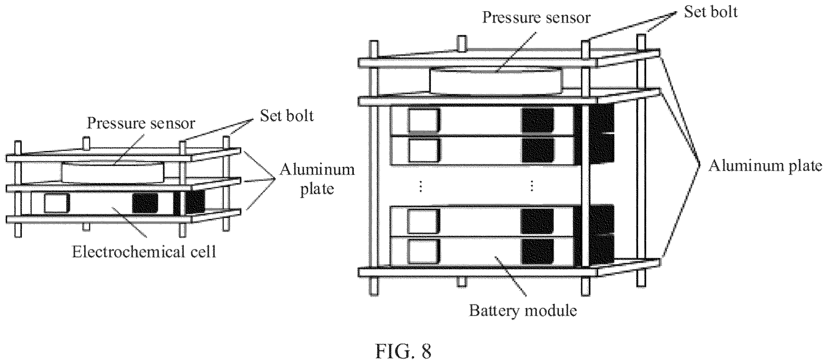

Optionally, to ensure accuracy and stability of measuring a pressure value of the lithium battery, the lithium battery and the pressure sensor may be fixed. For example, as shown in FIG. 8, when the lithium battery is a cell or a battery module, the cell and the pressure sensor may be fixed by using an aluminum plate, or the battery module and the pressure sensor may be fixed by using an aluminum plate, and the aluminum plate is fixed by using a bolt, to ensure accuracy and stability of measuring the pressure value.

In the step S401 to the step S403, to obtain relatively reliable information, the lithium battery is usually charged and discharged for multiple times at a same charge rate. As shown in FIG. 9, a process of charging and discharging for multiple times includes steps S901 to S907.

S901: Discharge operation: First, perform the discharge operation (which may also be referred to as a discharge operation) on the lithium battery, for example, in a constant current and constant voltage discharge manner or another discharge manner. An objective of the discharge operation is to make an SOC of the lithium battery approach 0%. For example, the SOC of the lithium battery is 0 to 5%.

S902: Resting operation: An objective of the resting operation is to enable the lithium battery to be in an electro-thermal-chemical-pressure quasi-equilibrium state. For example, duration of the resting operation may be 0 to 10 h.

S903: Select a charge rate, for example, the preset charge rate, the first charge rate, the second charge rate, or the third charge rate.

S904: Complete a full charging operation on the lithium battery at a selected charge rate, that is, charge the lithium battery at the selected charge rate, so that the lithium battery is in a fully charged state.

Optionally, during charging, a current value I, a voltage value V, a temperature value T, and a pressure value F of the lithium battery may be recorded.

Specifically, the completing a full charging operation on the lithium battery at a selected charge rate may include: setting a charge current of a charge/discharge unit based on the charge rate, and controlling the charge/discharge unit to charge the lithium battery at the set charge current. When the SOC of the lithium battery is 1, the full charging operation is completed.

S905: Perform the resting operation. An objective of the resting operation is the same as that of step S902.

S906: Perform the discharge operation on the lithium battery.

Optionally, during discharging, a current value I, a voltage value V, a temperature value T, and a pressure value F of the lithium battery may be recorded.

S907: Resting operation. After that, step S903 is returned to reselect a charge rate, and then a next step is performed.

It should be noted that when the lithium battery is discharged, a discharge operation may be performed at a specific discharge rate. A value of the discharge rate may be set by a person skilled in the art according to an actual situation. This is not specifically limited in this embodiment of this application. In addition, the duration of the resting operation may be set by a person skilled in the art according to an actual situation. This is also not specifically limited in this embodiment of this application.

The foregoing mainly describes the solutions provided in embodiments of this application from a perspective of a device to which a lithium battery is applied. It can be understood that, to implement the foregoing functions, the device in which the lithium battery is used includes a corresponding hardware structure and/or software module for performing each of the functions. A person skilled in the art should be easily aware that, with reference to units and algorithm steps in the examples described in embodiments disclosed in this specification, this application can be implemented in a form of hardware or a combination of hardware and computer software, Whether a function is performed by hardware or hardware driven by computer software depends on particular applications and design constraints of the technical solutions. A person skilled in the art may use different methods to implement the described functions for each particular application, but it should not be considered that the implementation goes beyond the scope of this application.

In embodiments of this application, the apparatus for detecting lithium plating in a lithium battery may be divided into functional modules based on the foregoing method examples. For example, each functional module may be obtained through division based on a corresponding function, or two or more functions may be integrated into one processing module. The integrated module may be implemented in a form of hardware, or may be implemented in a form of a software functional module. It should be noted that, in embodiments of this application, module division is an example, and is merely a logical function division. In actual implementation, another division manner may be used. An example in which each functional module is obtained through division based on each corresponding function is used below for description.

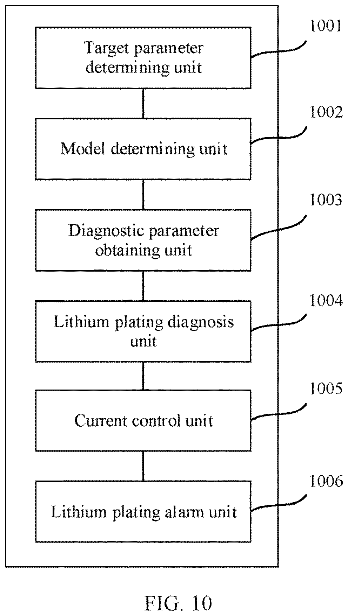

FIG. 10 is a schematic diagram of a structure of an apparatus for detecting lithium plating in a lithium battery according to an embodiment of this application. As shown in FIG. 10, the apparatus includes: a target parameter determining unit 1001, a model determining unit 1002, a diagnostic parameter obtaining unit 1003, a lithium plating diagnosis unit 1004, a current control unit 1005, and a lithium plating alarm unit 1006. The lithium plating detection apparatus may be a BMS, or a chip integrated with a BMS. In specific implementation, the target parameter determining unit 1001, the diagnostic parameter obtaining unit 1003, and the lithium plating diagnosis unit 1004 may all be a lithium plating safety diagnosis module 204 in the BMS shown in FIG. 2. In specific implementation, the current control unit 1005 may be the lithium plating prevention management module 203 in the BMS shown in FIG. 2. In specific implementation, the lithium plating alarm unit 1006 may be the communication module 207 in the BMS shown in FIG. 2.

The target parameter determining unit 1001 is configured to determine, based on a state of health SOH of a lithium battery, a temperature of the lithium battery, and a correspondence between the SOH of the lithium battery and the temperature of the lithium battery and a target parameter, a target parameter corresponding to the lithium battery. The target parameter corresponding to the lithium battery is a ratio of a polarization voltage of a negative electrode of the lithium battery to a polarization voltage of the lithium battery, and the polarization voltage is a difference between an actual voltage and an open-circuit voltage.

Optionally, before the target parameter corresponding to the lithium battery is determined, the target parameter determining unit 1001 is further configured to: charge the lithium battery at different temperatures and in different SOHs by using a preset charge rate, a first charge rate, a second charge rate, and a third charge rate; during charging of the lithium battery at the preset charge rate, determine corresponding open-circuit voltages OCVs of the lithium battery in different states of charge SOCs of the lithium battery and corresponding OCVs of the negative electrode of the lithium battery in different SOCs of the lithium battery, where the OCV of the negative electrode of the lithium battery is a reference potential of the negative electrode of the lithium battery relative to a lithium electrode; separately obtain corresponding temperatures and pressure of the lithium battery in different SOCs during charging of the lithium battery at the first charge rate, the second charge rate, or the third charge rate, where the corresponding pressure of the lithium battery in different SOCs is used to indicate a change of an external swelling volume of the lithium battery during charging; determine, based on the corresponding temperatures and pressure of the lithium battery in different SOCs, corresponding lithium plating effect pressure of the lithium battery in different SOCs, where the corresponding lithium plating effect pressure of the lithium battery in different SOCs is used to indicate a pressure change of the lithium battery caused by a lithium plating effect; determine the polarization voltage of the negative electrode of the lithium battery and the polarization voltage of the lithium battery based on the corresponding OCVs of the lithium battery in different SOCs of the lithium battery, the corresponding OCVs of the negative electrode of the lithium battery in different SOCs of the lithium battery, and the corresponding lithium plating effect pressure of the lithium battery in different SOCs; and finally establish a correspondence between the temperature of the lithium battery, the SOH of the lithium battery, and the target parameter, namely the ratio of the polarization voltage of the negative electrode of the lithium battery to the polarization voltage of the lithium battery.

In a possible implementation, the corresponding temperatures and pressure of the lithium battery in different SOCs include a first temperature and first pressure corresponding to the first charge rate, a second temperature and second pressure corresponding to the second charge rate, and third pressure corresponding to the third charge rate. The first pressure is total pressure caused by a lithium ion deintercalation effect, a temperature effect, and the lithium plating effect. The second pressure is total pressure caused by the lithium ion deintercalation effect and the temperature effect. The third pressure is pressure caused by the lithium ion deintercalation effect.

In a possible implementation, the target parameter determining unit 1001 is specifically configured to: determine an association relationship between temperature effect pressure of the lithium battery and the temperature of the lithium battery based on the second temperature and differences between the second pressure and the third pressure in different SOCs, where the temperature effect pressure of the lithium battery is used to indicate a pressure change caused by the temperature effect of the lithium battery at different temperatures; determine, based on the first temperature and the association relationship, corresponding temperature effect pressure of the lithium battery in different SOCs during charging of the lithium battery at the first charge rate; and finally determine, as the corresponding lithium plating effect pressure of the lithium battery in different SOCs, differences between the first pressure and a sum of the third pressure and the corresponding temperature effect pressure of the lithium battery in different SOCs.

In a possible implementation, the target parameter determining unit 1001 is specifically configured to: determine, as the polarization voltage of the negative electrode, a corresponding OCV of the negative electrode of the lithium battery in a start SOC, where the start SOC is a corresponding SOC when a pressure value of the lithium plating effect pressure changes from zero to non-zero; and determine, as the polarization voltage of the lithium battery, a difference between the (actual) voltage of the lithium battery in an end SOC and a corresponding OCV of the lithium battery in the end SOC, where the end SOC is an SOC corresponding to a maximum pressure value of the lithium plating effect pressure.

In a possible implementation, the preset lithium plating estimation model is

$$\begin{cases} SOC = \dfrac{\int I\mathrm{dt}}{Q} \\ V_{neg} = OCV_{neg} - V_{p,neg} = OCV_{neg}(SOC,T,SOH) - \alpha(V_{cell} - OCV_{cell}(SOC,T,SOH)) \end{cases}$$

, where I is the charge current of the lithium battery, Q is a rated capacity of the lithium battery, $\int I\mathrm{dt}$ represents an electric capacity of the lithium battery at a current moment, SOC is the state of charge of the lithium battery, $V_{neg}$ is the real-time potential value of the negative electrode of the lithium battery, $OCV_{neg}$ is the open-circuit voltage of the negative electrode of the lithium battery, $V_{p,neg}$ is the polarization voltage of the negative electrode of the lithium battery, T is the temperature of the lithium battery, SOH is the state of health of the lithium battery, $OCV_{neg}(SOC, T, SOH)$ is a function of $OCV_{neg}$ on SOC, T, and SOH, $\alpha$ is a target parameter in the lithium plating estimation model of the lithium battery, $V_{cell}$ is the voltage of the lithium battery, $OCV_{cell}(SOC, T, SOH)$ is a function of $OCV_{cell}$ on SOC, T, and SOH, and $V_{cell} - OCV_{cell}(SOC, T, SOH)$ represents the polarization voltage of the lithium battery.

The model determining unit 1002 is configured to substitute the target parameter corresponding to the lithium battery into a preset lithium plating estimation model, to obtain a lithium plating estimation model of the lithium battery.

The diagnostic parameter obtaining unit 1003 is configured to enter a charge current of the lithium battery, a voltage of the lithium battery, the temperature of the lithium battery, and the SOH of the lithium battery into the lithium plating estimation model of the lithium battery, to obtain a real-time potential value of the negative electrode of the lithium battery.

The lithium plating diagnosis unit 1004 is configured to: determine that lithium plating occurs in the lithium battery if the real-time potential value of the negative electrode of the lithium battery is less than zero.

Optionally, after lithium plating diagnosis is performed, the lithium plating alarm unit 1006 is configured to output lithium plating alarm information. The lithium plating alarm information includes at least one of a lithium plating occurrence moment, a lithium plating end moment, an SOC corresponding to the lithium plating occurrence moment, and a lithium plating severity level. The lithium plating severity level is determined based on lithium plating duration and the real-time potential value of the negative electrode.

Optionally, the current control unit 1005 is configured to adjust the charge current of the lithium battery based on the real-time potential value of the negative electrode.

Optionally, the current control unit 1005 is further configured to determine a maximum safe charge current of the lithium battery based on the lithium plating occurrence moment and the SOC corresponding to the lithium plating occurrence moment.

Based on this, an embodiment of this application further provides a device in which a lithium battery is used. The device includes a lithium battery, a charge/discharge device, and the apparatus for detecting lithium plating in a lithium battery shown in FIG. 10. In the device, the apparatus for detecting lithium plating in a lithium battery is configured to perform related steps in the foregoing method examples. For example, the apparatus for detecting lithium plating in a lithium battery is configured to perform S301 to S304 in the foregoing method examples, or S401 to S406, S901 to S907, or the like in the foregoing method examples.

A person of ordinary skill in the art may be aware that, the units and algorithm steps in the examples described with reference to the embodiments disclosed in this specification may be implemented by electronic hardware or a combination of computer software and electronic hardware. Whether the functions are performed by hardware or software depends on particular applications and design constraints of the technical solutions. A person skilled in the art may use different methods to implement the described functions for each particular application, but it should not be considered that the implementation goes beyond the scope of embodiments of this application.

It may be clearly understood by a person skilled in the art that, for the purpose of convenient and brief description, for a detailed working process of the foregoing system, apparatus, and unit, refer to a corresponding process in the foregoing method embodiment. Details are not described herein again.

In the several embodiments provided in embodiments of this application, it should be understood that the disclosed system, apparatuses, and method may be implemented in other manners. For example, the described apparatus embodiments are merely examples. For example, division into the units is merely logical function division and may be other division during actual implementation. For example, a plurality of units or components may be combined or integrated into another system, or some features may be ignored or not performed. In addition, the displayed or discussed mutual couplings or direct couplings or communication connections may be implemented through some interfaces. The indirect couplings or communication connections between the apparatuses or units may be implemented in electrical, mechanical, or another form.

The units described as separate parts may or may not be physically separate, and parts displayed as units may or may not be physical units, in other words, may be located in one position, or may be distributed on a plurality of network units. Some or all of the units may be selected based on actual requirements to achieve the objective of the solutions of embodiments.

In addition, functional units in embodiments of this application may be integrated into one processing unit, or each of the units may exist alone physically, or two or more units are integrated into one unit.

When functions are implemented in the form of a software functional unit and sold or used as an independent product, the functions may be stored in a computer-readable storage medium. Based on such an understanding, the technical solutions in embodiments of this application essentially, or the part contributing to the conventional technology, or some of the technical solutions may be implemented in a form of a software product. The computer software product is stored in a storage medium, and includes several instructions for instructing a computer device (which may be a personal computer, a server, or a network device) to perform all or some of the steps of the methods described in embodiments of this application. The storage medium includes any medium that can store program code, such as a USB flash drive, a removable hard disk, a read-only memory (ROM, Read-Only Memory), a random access memory (RAM, Random Access Memory), a magnetic disk, or an optical disc.

In conclusion, it should be noted that the foregoing descriptions are merely specific implementations of this application, but are not intended to limit the protection scope of this application. Any variation or replacement within the technical scope disclosed in this application shall fall within the protection scope of this application. Therefore, the protection scope of this application shall be subject to the protection scope of the claims.

## Claims

1. A method for detecting lithium plating in a lithium battery, comprising:

   determining, based on a state of health SOH of the lithium battery, a temperature of the lithium battery, and a correspondence between the SOH of the lithium battery and the temperature of the lithium battery and a target parameter, a target parameter corresponding to the lithium battery, wherein the target parameter corresponding to the lithium battery is a ratio of a polarization voltage of a negative electrode of the lithium battery to a polarization voltage of the lithium battery, and the polarization voltage is a difference between an actual voltage and an open-circuit voltage;
   substituting the target parameter corresponding to the lithium battery into a preset lithium plating estimation model, to obtain a lithium plating estimation model of the lithium battery;
   entering a charge current of the lithium battery, a voltage of the lithium battery, the temperature of the lithium battery, and the SOH of the lithium battery into the lithium plating estimation model of the lithium battery, to obtain a real-time potential value of the negative electrode of the lithium battery; and
   determining that lithium plating occurs in the lithium battery if the real-time potential value of the negative electrode of the lithium battery is less than zero.

2. The method for detecting lithium plating in a lithium battery according to claim 1, wherein before the determining, based on a state of health SOH of the lithium battery, a temperature of the lithium battery, and a correspondence between the SOH of the lithium battery and the temperature of the lithium battery and a target parameter, a target parameter corresponding to the lithium battery, the method comprises:

   charging the lithium battery at different temperatures and in different SOHs by using a preset charge rate, a first charge rate, a second charge rate, and a third charge rate;
   during charging of the lithium battery at the preset charge rate, determining corresponding open-circuit voltages OCVs of the lithium battery in different states of charge SOCs of the lithium battery and corresponding OCVs of the negative electrode of the lithium battery in different SOCs of the lithium battery, wherein the OCV of the negative electrode of the lithium battery is a reference potential of the negative electrode of the lithium battery relative to a lithium electrode;

during charging of the lithium battery at the first charge rate, the second charge rate, or the third charge rate, separately obtaining corresponding temperatures and pressure of the lithium battery in different SOCs, wherein the corresponding pressure of the lithium battery in different SOCs is used to indicate a change of an external swelling volume of the lithium battery during charging;

determining, based on the corresponding temperatures and pressure of the lithium battery in different SOCs, corresponding lithium plating effect pressure of the lithium battery in different SOCs, wherein the corresponding lithium plating effect pressure of the lithium battery in different SOCs is used to indicate a pressure change of the lithium battery caused by a lithium plating effect;

determining the polarization voltage of the negative electrode of the lithium battery and the polarization voltage of the lithium battery based on the corresponding OCVs of the lithium battery in different SOCs of the lithium battery, the corresponding OCVs of the negative electrode of the lithium battery in different SOCs of the lithium battery, and the corresponding lithium plating effect pressure of the lithium battery in different SOCs; and

establishing a correspondence between the temperature of the lithium battery, the SOH of the lithium battery, and the target parameter.

3. The method for detecting lithium plating in a lithium battery according to claim 2, wherein the corresponding temperatures and pressure of the lithium battery in different SOCs comprise a first temperature and first pressure corresponding to the first charge rate, a second temperature and second pressure corresponding to the second charge rate, and third pressure corresponding to the third charge rate, wherein

the first pressure is total pressure caused by a lithium ion deintercalation effect, a temperature effect, and the lithium plating effect, the second pressure is total pressure caused by the lithium ion deintercalation effect and the temperature effect, and the third pressure is pressure caused by the lithium ion deintercalation effect.

4. The method for detecting lithium plating in a lithium battery according to claim 3, wherein the determining, based on the corresponding temperatures and pressure of the lithium battery in different SOCs, corresponding lithium plating effect pressure of the lithium battery in different SOCs comprises:

determining an association relationship between temperature effect pressure of the lithium battery and the temperature of the lithium battery based on the second temperature and differences between the second pressure and the third pressure in different SOCs, wherein the temperature effect pressure of the lithium battery is used to indicate a pressure change caused by the temperature effect of the lithium battery at different temperatures;

determining, based on the first temperature and the association relationship, corresponding temperature effect pressure of the lithium battery in different SOCs during charging of the lithium battery at the first charge rate; and

determining, as the corresponding lithium plating effect pressure of the lithium battery in different SOCs, differences between the first pressure and a sum of the third pressure and the corresponding temperature effect pressure of the lithium battery in different SOCs.

5. The method for detecting lithium plating in a lithium battery according to any one of claims 2 to 4, wherein the determining the polarization voltage of the negative electrode of the lithium battery and the polarization voltage of the lithium battery based on the corresponding OCVs of the lithium battery in different SOCs of the lithium battery, the corresponding OCVs of the negative electrode of the lithium battery in different SOCs of the lithium battery, and the corresponding lithium plating effect pressure of the lithium battery in different SOCs comprises:

determining, as the polarization voltage of the negative electrode, a corresponding OCV of the negative electrode of the lithium battery in a start SOC, wherein the start SOC is a corresponding SOC when a pressure value of the lithium plating effect pressure changes from zero to non-zero; and

determining, as the polarization voltage of the lithium battery, a difference between the voltage of the lithium battery in an end SOC and a corresponding OCV of the lithium battery in the end SOC, wherein the end SOC is an SOC corresponding to a maximum pressure value of the lithium plating effect pressure.

6. The method for detecting lithium plating in a lithium battery according to any one of claims 1 to 5, wherein after the determining that lithium plating occurs in the lithium battery if the real-time potential value of the negative electrode of the lithium battery is less than zero, the method further comprises:

outputting lithium plating alarm information, wherein the lithium plating alarm information comprises at least one of a lithium plating occurrence moment, a lithium plating end moment, an SOC corresponding to the lithium plating occurrence moment, and a lithium plating severity level; and the lithium plating severity level is determined based on lithium plating duration and the real-time potential value of the negative electrode of the lithium battery.

7. An apparatus for detecting lithium plating in a lithium battery, comprising:

a target parameter determining unit, configured to determine, based on a state of health SOH of the lithium battery, a temperature of the lithium battery, and a correspondence between the SOH of the lithium battery and the temperature of the lithium battery and a target parameter, a target parameter corresponding to the lithium battery, wherein the target parameter corresponding to the lithium battery is a ratio of a polarization voltage of a negative electrode of the lithium battery to a polarization voltage of the lithium battery, and the polarization voltage is a difference between an actual voltage and an open-circuit voltage;

a model determining unit, configured to substitute the target parameter corresponding to the lithium battery into a preset lithium plating estimation model, to obtain a lithium plating estimation model of the lithium battery;

a diagnostic parameter obtaining unit, configured to enter a charge current of the lithium battery, a voltage of the lithium battery, the temperature of the lithium battery, and the SOH of the lithium battery into the lithium plating estimation model of the lithium battery, to obtain a real-time potential value of the negative electrode of the lithium battery; and

a lithium plating diagnosis unit, configured to: determine that lithium plating occurs in the lithium battery if the real-time potential value of the negative electrode of the lithium battery is less than zero.

8. The apparatus according to claim 7, wherein the target parameter determining unit is further configured to:

charge the lithium battery at different temperatures and in different SOHs by using a preset charge rate, a first charge rate, a second charge rate, and a third charge rate;

during charging of the lithium battery at the preset charge rate, determine corresponding open-circuit voltages OCVs of the lithium battery in different states of charge SOCs of the lithium battery and corresponding OCVs of the negative electrode of the lithium battery in different SOCs of the lithium battery, wherein the OCV of the negative electrode of the lithium battery is a reference potential of the negative electrode of the lithium battery relative to a lithium electrode;

separately obtain corresponding temperatures and pressure of the lithium battery in different SOCs during charging of the lithium battery at the first charge rate, the second charge rate, or the third charge rate, wherein the corresponding pressure of the lithium battery in different SOCs is used to indicate a change of an external swelling volume of the lithium battery during charging;

determine, based on the corresponding temperatures and pressure of the lithium battery in different SOCs, corresponding lithium plating effect pressure of the lithium battery in different SOCs, wherein the corresponding lithium plating effect pressure of the lithium battery in different SOCs is used to indicate a pressure change of the lithium battery caused by a lithium plating effect;

determine the polarization voltage of the negative electrode of the lithium battery and the polarization voltage of the lithium battery based on the corresponding OCVs of the lithium battery in different SOCs of the lithium battery, the corresponding OCVs of the negative electrode of the lithium battery in different SOCs of the lithium battery, and the corresponding lithium plating effect pressure of the lithium battery in different SOCs; and

establish a correspondence between the temperature of the lithium battery, the SOH of the lithium battery, and the target parameter.

9. The apparatus according to claim 8, wherein the corresponding temperatures and pressure of the lithium battery in different SOCs comprise a first temperature and first pressure corresponding to the first charge rate, a second temperature and second pressure corresponding to the second charge rate, and third pressure corresponding to the third charge rate, wherein

the first pressure is total pressure caused by a lithium ion deintercalation effect, a temperature effect, and the lithium plating effect, the second pressure is total pressure caused by the lithium ion deintercalation effect and the temperature effect, and the third pressure is pressure caused by the lithium ion deintercalation effect.

10. The apparatus according to claim 9, wherein the determining, based on the corresponding temperatures and pressure of the lithium battery in different SOCs, corresponding lithium plating effect pressure of the lithium battery in different SOCs comprises:

determining an association relationship between temperature effect pressure of the lithium battery and the temperature of the lithium battery based on the second temperature and differences between the second pressure and the third pressure in different SOCs, wherein the temperature effect pressure of the lithium battery is used to indicate a pressure change caused by the temperature effect of the lithium battery at different temperatures;

determining, based on the first temperature and the association relationship, corresponding temperature effect pressure of the lithium battery in different SOCs during charging of the lithium battery at the first charge rate; and determining, as the corresponding lithium plating effect pressure of the lithium battery in different SOCs, differences between the first pressure and a sum of the third pressure and the corresponding temperature effect pressure of the lithium battery in different SOCs.

11. The apparatus according to any one of claims 8 to 10, wherein the determining the polarization voltage of the negative electrode of the lithium battery and the polarization voltage of the lithium battery based on the corresponding OCVs of the lithium battery in different SOCs of the lithium battery, the corresponding OCVs of the negative electrode of the lithium battery in different SOCs of the lithium battery, and the corresponding lithium plating effect pressure of the lithium battery in different SOCs comprises:

determining, as the polarization voltage of the negative electrode, a corresponding OCV of the negative electrode of the lithium battery in a start SOC, wherein the start SOC is a corresponding SOC when a pressure value of the lithium plating effect pressure changes from zero to non-zero; and
determining, as the polarization voltage of the lithium battery, a difference between the voltage of the lithium battery in an end SOC and a corresponding OCV of the lithium battery in the end SOC, wherein the end SOC is an SOC corresponding to a maximum pressure value of the lithium plating effect pressure.

12. The apparatus according to any one of claims 7 to 11, wherein the apparatus further comprises a lithium plating alarm unit, wherein
the lithium plating alarm unit is configured to output lithium plating alarm information, wherein the lithium plating alarm information comprises at least one of a lithium plating occurrence moment, a lithium plating end moment, an SOC corresponding to the lithium plating occurrence moment, and a lithium plating severity level; and the lithium plating severity level is determined based on lithium plating duration and the real-time potential value of the negative electrode of the lithium battery.

13. The apparatus according to any one of claims 7 to 12, wherein the apparatus further comprises a current control unit, wherein
the current control unit is configured to adjust the charge current of the lithium battery based on the real-time potential value of the negative electrode of the lithium battery.

14. The apparatus according to claim 12 or 13, wherein the apparatus further comprises the current control unit, wherein the current control unit is configured to determine a maximum safe charge current of the lithium battery based on the lithium plating occurrence moment and the SOC corresponding to the lithium plating occurrence moment.

15. An electric vehicle, wherein the electric vehicle comprises a lithium battery, a charging/discharging device, and the apparatus for detecting lithium plating in a lithium battery according to any one of claims 7 to 14.

**Patentansprüche**

1. Verfahren zum Erkennen von Lithiumplattierung in einer Lithiumbatterie, umfassend:

Bestimmen, basierend auf einem Gesundheitszustand, SOH, der Lithiumbatterie, einer Temperatur der Lithiumbatterie und einer Entsprechung zwischen dem SOH der Lithiumbatterie und der Temperatur der Lithiumbatterie und einem Zielparameter, eines Zielparameters entsprechend der Lithiumbatterie, wobei der Zielparameter entsprechend der Lithiumbatterie ein Verhältnis einer Polarisationsspannung einer negativen Elektrode der Lithiumbatterie zu einer Polarisationsspannung der Lithiumbatterie ist und die Polarisationsspannung eine Differenz zwischen einer tatsächlichen Spannung und einer Leerlaufspannung ist;
Substituieren des Zielparameters entsprechend der Lithiumbatterie in ein voreingestelltes Schätzmodell für Lithiumplattierung, um ein Schätzmodell für Lithiumplattierung der Lithiumbatterie zu erlangen;
Eingeben eines Ladestroms der Lithiumbatterie, einer Spannung der Lithiumbatterie, der Temperatur der Lithiumbatterie und des SOH der Lithiumbatterie in das Schätzmodell für Lithiumplattierung der Lithiumbatterie, um einen potenziellen Wert in Echtzeit der negativen Elektrode der Lithiumbatterie zu erlangen; und
Bestimmen, dass in der Lithiumbatterie Lithiumplattierung auftritt, wenn der potenzielle Wert in Echtzeit der negativen Elektrode der Lithiumbatterie kleiner als null ist.

2.  Verfahren zum Erkennen von Lithiumplattierung in einer Lithiumbatterie nach Anspruch 1, wobei das Verfahren vor dem Bestimmen, basierend auf einem Gesundheitszustand, SOH, der Lithiumbatterie, einer Temperatur der Lithiumbatterie und einer Entsprechung zwischen dem SOH der Lithiumbatterie und der Temperatur der Lithiumbatterie und einem Zielparameter, eines Zielparameters entsprechend der Lithiumbatterie, Folgendes umfasst:

Laden der Lithiumbatterie bei unterschiedlichen Temperaturen und in verschiedenen SOHs unter Verwendung einer voreingestellten Laderate, einer ersten Laderate, einer zweiten Laderate und einer dritten Laderate;
während des Ladens der Lithiumbatterie mit der voreingestellten Laderate, Bestimmen entsprechender Leerlaufspannungen, OCVs, der Lithiumbatterie in verschiedenen Ladezuständen, SOCs, der Lithiumbatterie und entsprechender OCVs der negativen Elektrode der Lithiumbatterie in verschiedenen SOCs der Lithiumbatterie, wobei die OCV der negativen Elektrode der Lithiumbatterie ein Referenzpotenzial der negativen Elektrode der Lithiumbatterie relativ zu einer Lithiumelektrode ist;
während des Ladens der Lithiumbatterie mit der ersten Laderate, der zweiten Laderate oder der dritten Laderate, separates Erlangen entsprechender Temperaturen und Druck der Lithiumbatterie in verschiedenen SOCs, wobei der entsprechende Druck der Lithiumbatterie in verschiedenen SOCs verwendet wird, um eine Änderung eines externen Quellvolumens der Lithiumbatterie während des Ladens anzuzeigen;
Bestimmen, basierend auf den entsprechenden Temperaturen und Druck der Lithiumbatterie in verschiedenen SOCs, eines entsprechenden Drucks für den Lithiumplattierungseffekt der Lithiumbatterie in verschiedenen SOCs, wobei der entsprechende Druck für den Lithiumplattierungseffekt der Lithiumbatterie in verschiedenen SOCs verwendet wird, um eine durch einen Lithiumplattierungseffekt verursachte Druckänderung der Lithiumbatterie anzuzeigen;
Bestimmen der Polarisationsspannung der negativen Elektrode der Lithiumbatterie und der Polarisationsspannung der Lithiumbatterie basierend auf den entsprechenden OCVs der Lithiumbatterie in verschiedenen SOCs der Lithiumbatterie, den entsprechenden OCVs der negativen Elektrode der Lithiumbatterie in verschiedenen SOCs der Lithiumbatterie und dem entsprechenden Druck für den Lithiumplattierungseffekt der Lithiumbatterie in verschiedenen SOCs; und
Herstellen einer Entsprechung zwischen der Temperatur der Lithiumbatterie, dem SOH der Lithiumbatterie und dem Zielparameter.

3.  Verfahren zum Erkennen von Lithiumplattierung in einer Lithiumbatterie nach Anspruch 2, wobei die entsprechenden Temperaturen und Druck der Lithiumbatterie in verschiedenen SOCs eine erste Temperatur und einen ersten Druck entsprechend der ersten Laderate, eine zweite Temperatur und einen zweiten Druck entsprechend der zweiten Laderate und einen dritten Druck entsprechend der dritten Laderate umfassen, wobei der erste Druck ein Gesamtdruck ist, der durch einen Lithium-Ionen-Deinterkalationseffekt, einen Temperatureffekt und den Lithiumplattierungseffekt verursacht wird, der zweite Druck ein Gesamtdruck ist, der durch den Lithium-Ionen-Deinterkalationseffekt und den Temperatureffekt verursacht wird, und der dritte Druck ein Druck ist, der durch den Lithium-Ionen-Deinterkalationseffekt verursacht wird.

4.  Verfahren zum Erkennen von Lithiumplattierung in einer Lithiumbatterie nach Anspruch 3, wobei das Bestimmen, basierend auf den entsprechenden Temperaturen und Druck der Lithiumbatterie in verschiedenen SOCs, eines entsprechenden Drucks für den Lithiumplattierungseffekt der Lithiumbatterie in verschiedenen SOCs Folgendes umfasst:

Bestimmen einer Zuordnungsbeziehung zwischen dem Druck für den Temperatureffekt der Lithiumbatterie und der Temperatur der Lithiumbatterie basierend auf der zweiten Temperatur und Differenzen zwischen dem zweiten Druck und dem dritten Druck in verschiedenen SOCs, wobei der Druck für den Temperatureffekt der Lithiumbatterie verwendet wird, um eine Druckänderung anzuzeigen, die durch den Temperatureffekt der Lithiumbatterie bei verschiedenen Temperaturen verursacht wird;
Bestimmen, basierend auf der ersten Temperatur und der Zuordnungsbeziehung, eines entsprechenden Drucks für den Temperatureffekt der Lithiumbatterie in verschiedenen SOCs während des Ladens der Lithiumbatterie mit der ersten Laderate; und
Bestimmen, als den entsprechenden Druck für den Lithiumplattierungseffekt der Lithiumbatterie in verschiedenen SOCs, von Differenzen zwischen dem ersten Druck und einer Summe aus dem dritten Druck und dem entsprechenden Druck für den Temperatureffekt der Lithiumbatterie in verschiedenen SOCs.

**5.** Verfahren zum Erkennen von Lithiumplattierung in einer Lithiumbatterie nach einem der Ansprüche 2 bis 4, wobei das Bestimmen der Polarisationsspannung der negativen Elektrode der Lithiumbatterie und der Polarisationsspannung der Lithiumbatterie basierend auf den entsprechenden OCVs der Lithiumbatterie in verschiedenen SOCs der Lithiumbatterie, den entsprechenden OCVs der negativen Elektrode der Lithiumbatterie in verschiedenen SOCs der Lithiumbatterie und dem entsprechenden Druck für den Lithiumplattierungseffekt der Lithiumbatterie in verschiedenen SOCs Folgendes umfasst:

Bestimmen, als die Polarisationsspannung der negativen Elektrode, einer entsprechenden OCV der negativen Elektrode der Lithiumbatterie in einem Start-SOC, wobei der Start-SOC ein entsprechender SOC ist, wenn sich ein Druckwert des Drucks für den Lithiumplattierungseffekt von null auf ungleich null ändert; und
Bestimmen, als die Polarisationsspannung der Lithiumbatterie, einer Differenz zwischen der Spannung der Lithiumbatterie in einem End-SOC und einer entsprechenden OCV der Lithiumbatterie in dem End-SOC, wobei der End-SOC ein SOC entsprechend einem maximalen Druckwert des Drucks für den Lithiumplattierungseffekt ist.

**6.** Verfahren zum Erkennen von Lithiumplattierung in einer Lithiumbatterie nach einem der Ansprüche 1 bis 5, wobei das Verfahren nach dem Bestimmen, dass Lithiumplattierung in der Lithiumbatterie auftritt, wenn der potenzielle Wert in Echtzeit der negativen Elektrode der Lithiumbatterie kleiner als null ist, ferner Folgendes umfasst:
Ausgeben von Alarminformationen für die Lithiumplattierung, wobei die Alarminformationen für die Lithiumplattierung mindestens einen von einem Zeitpunkt des Auftretens von Lithiumplattierung, einem Zeitpunkt des Endes von Lithiumplattierung, einem SOC entsprechend dem Zeitpunkt des Auftretens von Lithiumplattierung und einem Schweregrad von Lithiumplattierung umfassen; und der Schweregrad von Lithiumplattierung basierend auf der Dauer von Lithiumplattierung und dem potenziellen Wert in Echtzeit der negativen Elektrode der Lithiumbatterie bestimmt wird.

**7.** Vorrichtung zum Erkennen von Lithiumplattierung in einer Lithiumbatterie, umfassend:

eine Zielparameterbestimmungseinheit, die dazu konfiguriert ist, basierend auf einem Gesundheitszustand, SOH, der Lithiumbatterie, einer Temperatur der Lithiumbatterie und einer Entsprechung zwischen dem SOH der Lithiumbatterie und der Temperatur der Lithiumbatterie und einem Zielparameter, einen Zielparameters entsprechend der Lithiumbatterie zu bestimmen,
wobei der Zielparameter entsprechend der Lithiumbatterie ein Verhältnis einer Polarisationsspannung einer negativen Elektrode der Lithiumbatterie zu einer Polarisationsspannung der Lithiumbatterie ist und die Polarisationsspannung eine Differenz zwischen einer tatsächlichen Spannung und einer Leerlaufspannung ist;
eine Modellbestimmungseinheit, die dazu konfiguriert ist, den Zielparameter entsprechend der Lithiumbatterie in ein voreingestelltes Schätzmodell für Lithiumplattierung zu substituieren, um ein Schätzmodell für Lithiumplattierung der Lithiumbatterie zu erlangen;
eine Diagnoseparametererlangungseinheit, die dazu konfiguriert ist, einen Ladestrom der Lithiumbatterie, eine Spannung der Lithiumbatterie, die Temperatur der Lithiumbatterie und den SOH der Lithiumbatterie in das Schätzmodell für Lithiumplattierung der Lithiumbatterie einzugeben, um einen potenziellen Wert in Echtzeit der negativen Elektrode der Lithiumbatterie zu erlangen; und
eine Diagnoseeinheit für Lithiumplattierung, die dazu konfiguriert ist: zu bestimmen, dass eine Lithiumplattierung in der Lithiumbatterie auftritt, wenn der potenzielle Wert in Echtzeit der negativen Elektrode der Lithiumbatterie kleiner als null ist.

**8.** Vorrichtung nach Anspruch 7, wobei die Zielparameterbestimmungseinheit ferner dazu konfiguriert ist:

die Lithiumbatterie bei unterschiedlichen Temperaturen und in verschiedenen SOHs unter Verwendung einer voreingestellten Laderate, einer ersten Laderate, einer zweiten Laderate und einer dritten Laderate zu laden;
während des Ladens der Lithiumbatterie mit der voreingestellten Laderate entsprechende Leerlaufspannungen, OCVs, der Lithiumbatterie in verschiedenen Ladezuständen, SOCs, der Lithiumbatterie und entsprechende OCVs der negativen Elektrode der Lithiumbatterie in verschiedenen SOCs der Lithiumbatterie zu bestimmen, wobei die OCV der negativen Elektrode der Lithiumbatterie ein Referenzpotenzial der negativen Elektrode der Lithiumbatterie relativ zu einer Lithiumelektrode ist;
entsprechende Temperaturen und Druck der Lithiumbatterie in verschiedenen SOCs während des Ladens der Lithiumbatterie mit der ersten Laderate, der zweiten Laderate oder der dritten Laderate separat zu erlangen, wobei der entsprechende Druck der Lithiumbatterie in verschiedenen SOCs verwendet wird, um eine Änderung eines externen Quellvolumens der Lithiumbatterie während des Ladens anzuzeigen;

basierend auf den entsprechenden Temperaturen und Druck der Lithiumbatterie in verschiedenen SOCs, einen entsprechenden Druck für den Lithiumplattierungseffekt der Lithiumbatterie in verschiedenen SOCs zu bestimmen, wobei der entsprechende Druck für den Lithiumplattierungseffekt der Lithiumbatterie in verschiedenen SOCs verwendet wird, um eine durch einen Lithiumplattierungseffekt verursachte Druckänderung der Lithiumbatterie anzuzeigen;

die Polarisationsspannung der negativen Elektrode der Lithiumbatterie und die Polarisationsspannung der Lithiumbatterie basierend auf den entsprechenden OCVs der Lithiumbatterie in verschiedenen SOCs der Lithiumbatterie, den entsprechenden OCVs der negativen Elektrode der Lithiumbatterie in verschiedenen SOCs der Lithiumbatterie und dem entsprechenden Druck für den Lithiumplattierungseffekt der Lithiumbatterie in verschiedenen SOCs zu bestimmen; und

eine Entsprechung zwischen der Temperatur der Lithiumbatterie, dem SOH der Lithiumbatterie und dem Zielparameter herzustellen.

9. Vorrichtung nach Anspruch 8, wobei die entsprechenden Temperaturen und Druck der Lithiumbatterie in verschiedenen SOCs eine erste Temperatur und einen ersten Druck entsprechend der ersten Laderate, eine zweite Temperatur und einen zweiten Druck entsprechend der zweiten Laderate und einen dritten Druck entsprechend der dritten Laderate umfassen, wobei der erste Druck ein Gesamtdruck ist, der durch einen Lithium-Ionen-Deinterkalationseffekt, einen Temperatureffekt und den Lithiumplattierungseffekt verursacht wird, der zweite Druck ein Gesamtdruck ist, der durch den Lithium-Ionen-Deinterkalationseffekt und den Temperatureffekt verursacht wird, und der dritte Druck ein Druck ist, der durch den Lithium-Ionen-Deinterkalationseffekt verursacht wird.

10. Vorrichtung nach Anspruch 9, wobei das Bestimmen, basierend auf den entsprechenden Temperaturen und Druck der Lithiumbatterie in verschiedenen SOCs, eines entsprechenden Drucks für den Lithiumplattierungseffekt der Lithiumbatterie in verschiedenen SOCs Folgendes umfasst:

Bestimmen einer Zuordnungsbeziehung zwischen dem Druck für den Temperatureffekt der Lithiumbatterie und der Temperatur der Lithiumbatterie basierend auf der zweiten Temperatur und Differenzen zwischen dem zweiten Druck und dem dritten Druck in verschiedenen SOCs, wobei der Druck für den Temperatureffekt der Lithiumbatterie verwendet wird, um eine Druckänderung anzuzeigen, die durch den Temperatureffekt der Lithiumbatterie bei verschiedenen Temperaturen verursacht wird;

Bestimmen, basierend auf der ersten Temperatur und der Zuordnungsbeziehung, eines entsprechenden Drucks für den Temperatureffekt der Lithiumbatterie in verschiedenen SOCs während des Ladens der Lithiumbatterie mit der ersten Laderate; und

Bestimmen, als den entsprechenden Druck für den Lithiumplattierungseffekt der Lithiumbatterie in verschiedenen SOCs, von Differenzen zwischen dem ersten Druck und einer Summe aus dem dritten Druck und dem entsprechenden Druck für den Temperatureffekt der Lithiumbatterie in verschiedenen SOCs.

11. Vorrichtung nach einem der Ansprüche 8 bis 10, wobei das Bestimmen der Polarisationsspannung der negativen Elektrode der Lithiumbatterie und der Polarisationsspannung der Lithiumbatterie basierend auf den entsprechenden OCVs der Lithiumbatterie in verschiedenen SOCs der Lithiumbatterie, den entsprechenden OCVs der negativen Elektrode der Lithiumbatterie in verschiedenen SOCs der Lithiumbatterie und dem entsprechenden Druck für den Lithiumplattierungseffekt der Lithiumbatterie in verschiedenen SOCs Folgendes umfasst:

Bestimmen, als die Polarisationsspannung der negativen Elektrode, einer entsprechenden OCV der negativen Elektrode der Lithiumbatterie in einem Start-SOC, wobei der Start-SOC ein entsprechender SOC ist, wenn sich ein Druckwert des Drucks für den Lithiumplattierungseffekt von null auf ungleich null ändert; und

Bestimmen, als die Polarisationsspannung der Lithiumbatterie, einer Differenz zwischen der Spannung der Lithiumbatterie in einem End-SOC und einer entsprechenden OCV der Lithiumbatterie in dem End-SOC, wobei der End-SOC ein SOC entsprechend einem maximalen Druckwert des Drucks für den Lithiumplattierungseffekt ist.

12. Vorrichtung nach einem der Ansprüche 7 bis 11, wobei die Vorrichtung ferner eine Alarmeinheit für Lithiumplattierung umfasst, wobei

die Alarmeinheit für Lithiumplattierung dazu konfiguriert ist, Alarminformationen für die Lithiumplattierung auszugeben, wobei die Alarminformationen für die Lithiumplattierung mindestens einen von einem Zeitpunkt des Auftretens von Lithiumplattierung, einem Zeitpunkt des Endes von Lithiumplattierung, einem SOC entsprechend dem Zeitpunkt des Auftretens von Lithiumplattierung und einem Schweregrad von Lithiumplattierung umfassen; und der Schweregrad von Lithiumplattierung basierend auf der Dauer von Lithiumplattierung und dem potenziellen Wert in Echtzeit der negativen Elektrode der Lithiumbatterie bestimmt wird.

**13.** Vorrichtung nach einem der Ansprüche 7 bis 12, wobei die Vorrichtung ferner eine Stromsteuereinheit umfasst, wobei die Stromsteuereinheit dazu konfiguriert, den Ladestrom der Lithiumbatterie basierend auf dem potenziellen Wert in Echtzeit der negativen Elektrode der Lithiumbatterie einzustellen.

**14.** Vorrichtung nach Anspruch 12 oder 13, wobei die Vorrichtung ferner die Stromsteuereinheit umfasst, wobei die Stromsteuereinheit dazu konfiguriert ist, einen maximal sicheren Ladestrom der Lithiumbatterie basierend auf dem Zeitpunkt des Auftretens der Lithiumplattierung und dem SOC entsprechend dem Zeitpunkt des Auftretens der Lithiumplattierung zu bestimmen.

**15.** Elektrofahrzeug, wobei das Elektrofahrzeug eine Lithiumbatterie, eine Lade-/Entladeeinrichtung und die Vorrichtung zum Erkennen von Lithiumplattierung in einer Lithiumbatterie nach einem der Ansprüche 7 bis 14 umfasst.

**Revendications**

**1.** Procédé de détection de placage de lithium dans une batterie au lithium, comprenant :

la détermination, sur la base d'un état de santé, SOH, de la batterie au lithium, d'une température de la batterie au lithium, et d'une correspondance entre le SOH de la batterie au lithium et la température de la batterie au lithium et un paramètre cible, d'un paramètre cible correspondant à la batterie au lithium, dans lequel le paramètre cible correspondant à la batterie au lithium est un rapport entre une tension de polarisation d'une électrode négative de la batterie au lithium et une tension de polarisation de la batterie au lithium, et la tension de polarisation est une différence entre une tension réelle et une tension de circuit ouvert ;
le remplacement du paramètre cible correspondant à la batterie au lithium dans un modèle d'estimation de placage de lithium prédéfini, pour obtenir un modèle d'estimation de placage de lithium de la batterie au lithium ;
l'entrée d'un courant de charge de la batterie au lithium, d'une tension de la batterie au lithium, de la température de la batterie au lithium et du SOH de la batterie au lithium dans le modèle d'estimation de placage de lithium de la batterie au lithium, pour obtenir une valeur de potentiel en temps réel de l'électrode négative de la batterie au lithium ; et
la détermination qu'un placage de lithium se produit dans la batterie au lithium si la valeur de potentiel en temps réel de l'électrode négative de la batterie au lithium est inférieure à zéro.

**2.** Procédé de détection de placage de lithium dans une batterie au lithium selon la revendication 1, dans lequel, avant la détermination, sur la base d'un état de santé, SOH, de la batterie au lithium, d'une température de la batterie au lithium et d'une correspondance entre le SOH de la batterie au lithium et la température de la batterie au lithium et un paramètre cible, d'un paramètre cible correspondant à la batterie au lithium, le procédé comprend :

la charge de la batterie au lithium à différentes températures et à différents SOH à l'aide d'un taux de charge prédéfini, d'un premier taux de charge, d'un deuxième taux de charge et d'un troisième taux de charge ;
pendant la charge de la batterie au lithium au taux de charge prédéfini, la détermination des tensions de circuit ouvert, OCV, correspondantes de la batterie au lithium dans différents états de charge, SOC, de la batterie au lithium et des OCV correspondantes de l'électrode négative de la batterie au lithium dans différents SOC de la batterie au lithium, dans lequel l'OCV de l'électrode négative de la batterie au lithium est un potentiel de référence de l'électrode négative de la batterie au lithium par rapport à une électrode au lithium ;
pendant la charge de la batterie au lithium au premier taux de charge, au deuxième taux de charge ou au troisième taux de charge, l'obtention séparée de températures et d'une pression correspondantes de la batterie au lithium dans différents SOC, dans lequel la pression correspondante de la batterie au lithium dans différents SOC est utilisée pour indiquer un changement d'un volume de gonflement externe de la batterie au lithium pendant la charge ;
la détermination, sur la base des températures et de la pression correspondantes de la batterie au lithium dans différents SOC, d'une pression d'effet de placage de lithium correspondante de la batterie au lithium dans différents SOC, dans lequel la pression d'effet de placage de lithium correspondante de la batterie au lithium dans différents SOC est utilisée pour indiquer un changement de pression de la batterie au lithium provoqué par un effet de placage de lithium ;
la détermination de la tension de polarisation de l'électrode négative de la batterie au lithium et de la tension de polarisation de la batterie au lithium sur la base des OCV correspondantes de la batterie au lithium dans différents SOC de la batterie au lithium, des OCV correspondantes de l'électrode négative de la batterie au lithium dans différents SOC de la batterie au lithium et de la pression d'effet de placage de lithium correspondante de la batterie au lithium dans différents SOC ; et

l'établissement d'une correspondance entre la température de la batterie au lithium, le SOH de la batterie au lithium et le paramètre cible.

3. Procédé de détection de placage de lithium dans une batterie au lithium selon la revendication 2, dans lequel les températures et la pression correspondantes de la batterie au lithium dans différents SOC comprennent une première température et une première pression correspondant au premier taux de charge, une seconde température et une deuxième pression correspondant au deuxième taux de charge, et une troisième pression correspondant au troisième taux de charge, dans lequel la première pression est une pression totale provoquée par un effet de désintercalation des ions lithium, un effet thermique et l'effet de placage de lithium, la deuxième pression est une pression totale provoquée par l'effet de désintercalation des ions lithium et l'effet thermique, et la troisième pression est une pression provoquée par l'effet de désintercalation des ions lithium.

4. Procédé de détection de placage de lithium dans une batterie au lithium selon la revendication 3, dans lequel la détermination, sur la base des températures et de la pression correspondantes de la batterie au lithium dans différents SOC, d'une pression d'effet de placage de lithium correspondante de la batterie au lithium dans différents SOC comprend :

la détermination d'une relation d'association entre la pression d'effet thermique de la batterie au lithium et la température de la batterie au lithium sur la base de la seconde température et des différences entre la deuxième pression et la troisième pression dans différents SOC, dans lequel la pression d'effet thermique de la batterie au lithium est utilisée pour indiquer un changement de pression provoqué par l'effet thermique de la batterie au lithium à différentes températures ;

la détermination, sur la base de la première température et de la relation d'association, d'une pression d'effet thermique correspondante de la batterie au lithium dans différents SOC pendant la charge de la batterie au lithium au premier taux de charge ; et

la détermination, en tant que pression d'effet de placage de lithium correspondante de la batterie au lithium dans différents SOC, de différences entre la première pression et une somme de la troisième pression et de la pression d'effet thermique correspondante de la batterie au lithium dans différents SOC.

5. Procédé de détection de placage de lithium dans une batterie au lithium selon l'une quelconque des revendications 2 à 4, dans lequel la détermination de la tension de polarisation de l'électrode négative de la batterie au lithium et de la tension de polarisation de la batterie au lithium sur la base des OCV correspondantes de la batterie au lithium dans différents SOC de la batterie au lithium, des OCV correspondantes de l'électrode négative de la batterie au lithium dans différents SOC de la batterie au lithium et de la pression d'effet de placage de lithium correspondante de la batterie au lithium dans différents SOC comprend :

la détermination, en tant que tension de polarisation de l'électrode négative, d'une OCV correspondante de l'électrode négative de la batterie au lithium dans un SOC de départ, dans lequel le SOC de départ est un SOC correspondant lorsqu'une valeur de pression de la pression d'effet de placage de lithium passe de zéro à un chiffre non nul ; et

la détermination, en tant que tension de polarisation de la batterie au lithium, d'une différence entre la tension de la batterie au lithium dans un SOC de fin et une OCV correspondante de la batterie au lithium dans le SOC de fin, dans lequel le SOC de fin est un SOC correspondant à une valeur de pression maximale de la pression d'effet de placage de lithium.

6. Procédé de détection de placage de lithium dans une batterie au lithium selon l'une quelconque des revendications 1 à 5, dans lequel, après la détermination que le placage de lithium se produit dans la batterie au lithium si la valeur de potentiel en temps réel de l'électrode négative de la batterie au lithium est inférieure à zéro, le procédé comprend en outre :

l'émission d'informations d'alarme de placage de lithium, dans lequel les informations d'alarme de placage de lithium comprennent au moins l'un parmi un moment d'occurrence de placage de lithium, un moment de fin de placage de lithium, un SOC correspondant au moment d'occurrence de placage de lithium et un niveau de gravité de placage de lithium ; et le niveau de gravité de placage de lithium est déterminé sur la base de la durée de placage de lithium et de la valeur de potentiel en temps réel de l'électrode négative de la batterie au lithium.

**7.** Appareil de détection de placage de lithium dans une batterie au lithium, comprenant :

une unité de détermination de paramètre cible, configurée pour déterminer, sur la base d'un état de santé, SOH, de la batterie au lithium, d'une température de la batterie au lithium et d'une correspondance entre le SOH de la batterie au lithium et la température de la batterie au lithium et un paramètre cible, un paramètre cible correspondant à la batterie au lithium, dans lequel le paramètre cible correspondant à la batterie au lithium est un rapport entre une tension de polarisation d'une électrode négative de la batterie au lithium et une tension de polarisation de la batterie au lithium, et la tension de polarisation est une différence entre une tension réelle et une tension de circuit ouvert ;

une unité de détermination de modèle, configurée pour remplacer le paramètre cible correspondant à la batterie au lithium dans un modèle d'estimation de placage de lithium prédéfini, pour obtenir un modèle d'estimation de placage de lithium de la batterie au lithium ;

une unité d'obtention de paramètre de diagnostic, configurée pour entrer un courant de charge de la batterie au lithium, une tension de la batterie au lithium, la température de la batterie au lithium et le SOH de la batterie au lithium dans le modèle d'estimation de placage de lithium de la batterie au lithium, pour obtenir une valeur de potentiel en temps réel de l'électrode négative de la batterie au lithium ; et

une unité de diagnostic de placage de lithium, configurée pour : déterminer qu'un placage de lithium se produit dans la batterie au lithium si la valeur de potentiel en temps réel de l'électrode négative de la batterie au lithium est inférieure à zéro.

**8.** Appareil selon la revendication 7, dans lequel l'unité de détermination de paramètre cible est en outre configurée pour :

charger la batterie au lithium à différentes températures et à différents SOH à l'aide d'un taux de charge prédéfini, d'un premier taux de charge, d'un deuxième taux de charge et d'un troisième taux de charge ;

pendant la charge de la batterie au lithium au taux de charge prédéfini, déterminer des tensions de circuit ouvert, OCV,

correspondantes de la batterie au lithium dans différents états de charge, SOC, de la batterie au lithium et des OCV correspondantes de l'électrode négative de la batterie au lithium dans différents SOC de la batterie au lithium, dans lequel l'OCV de l'électrode négative de la batterie au lithium est un potentiel de référence de l'électrode négative de la batterie au lithium par rapport à une électrode au lithium ;

obtenir séparément des températures et une pression correspondantes de la batterie au lithium dans différents SOC pendant la charge de la batterie au lithium au premier taux de charge, au deuxième taux de charge ou au troisième taux de charge, dans lequel la pression correspondante de la batterie au lithium dans différents SOC est utilisée pour indiquer un changement d'un volume de gonflement externe de la batterie au lithium pendant la charge ;

déterminer, sur la base des températures et de la pression correspondantes de la batterie au lithium dans différents SOC, une pression d'effet de placage de lithium correspondante de la batterie au lithium dans différents SOC, dans lequel la pression d'effet de placage de lithium correspondante de la batterie au lithium dans différents SOC est utilisée pour indiquer un changement de pression de la batterie au lithium provoqué par un effet de placage de lithium ;

déterminer la tension de polarisation de l'électrode négative de la batterie au lithium et la tension de polarisation de la batterie au lithium sur la base des OCV correspondantes de la batterie au lithium dans différents SOC de la batterie au lithium, des OCV correspondantes de l'électrode négative de la batterie au lithium dans différents SOC de la batterie au lithium et de la pression d'effet de placage de lithium correspondante de la batterie au lithium dans différents SOC ; et

établir une correspondance entre la température de la batterie au lithium, le SOH de la batterie au lithium et le paramètre cible.

**9.** Appareil selon la revendication 8, dans lequel les températures et la pression correspondantes de la batterie au lithium dans différents SOC comprennent une première température et une première pression correspondant au premier taux de charge, une seconde température et une deuxième pression correspondant au deuxième taux de charge, et une troisième pression correspondant au troisième taux de charge, dans lequel la première pression est une pression totale provoquée par un effet de désintercalation des ions lithium, un effet thermique et l'effet de placage de lithium, la deuxième pression est une pression totale provoquée par l'effet de désintercalation des ions lithium et l'effet thermique, et la troisième pression est une pression provoquée par l'effet de désintercalation des ions lithium.

**10.** Appareil selon la revendication 9, dans lequel la détermination, sur la base des températures et de la pression correspondantes de la batterie au lithium dans différents SOC, d'une pression d'effet de placage de lithium correspondante de la batterie au lithium dans différents SOC comprend :

la détermination d'une relation d'association entre la pression d'effet thermique de la batterie au lithium et la température de la batterie au lithium sur la base de la seconde température et des différences entre la deuxième pression et la troisième pression dans différents SOC, dans lequel la pression d'effet thermique de la batterie au lithium est utilisée pour indiquer un changement de pression provoqué par l'effet thermique de la batterie au lithium à différentes températures ;

la détermination, sur la base de la première température et de la relation d'association, d'une pression d'effet thermique correspondante de la batterie au lithium dans différents SOC pendant la charge de la batterie au lithium au premier taux de charge ; et

la détermination, en tant que pression d'effet de placage de lithium correspondante de la batterie au lithium dans différents SOC, de différences entre la première pression et une somme de la troisième pression et de la pression d'effet thermique correspondante de la batterie au lithium dans différents SOC.

**11.** Appareil selon l'une quelconque des revendications 8 à 10, dans lequel la détermination de la tension de polarisation de l'électrode négative de la batterie au lithium et de la tension de polarisation de la batterie au lithium sur la base des OCV correspondantes de la batterie au lithium dans différents SOC de la batterie au lithium, des OCV correspondantes de l'électrode négative de la batterie au lithium dans différents SOC de la batterie au lithium et de la pression d'effet de placage de lithium correspondante de la batterie au lithium dans différents SOC comprend :

la détermination, en tant que tension de polarisation de l'électrode négative, d'une OCV correspondante de l'électrode négative de la batterie au lithium dans un SOC de départ, dans lequel le SOC de départ est un SOC correspondant lorsqu'une valeur de pression de la pression d'effet de placage de lithium passe de zéro à un chiffre non nul ; et

la détermination, en tant que tension de polarisation de la batterie au lithium, d'une différence entre la tension de la batterie au lithium dans un SOC de fin et une OCV correspondante de la batterie au lithium dans le SOC de fin, dans lequel le SOC de fin est un SOC correspondant à une valeur de pression maximale de la pression d'effet de placage de lithium.

**12.** Appareil selon l'une quelconque des revendications 7 à 11, dans lequel l'appareil comprend en outre une unité d'alarme de placage de lithium, dans lequel

l'unité d'alarme de placage de lithium est configurée pour émettre des informations d'alarme de placage de lithium, dans lequel les informations d'alarme de placage de lithium comprennent au moins l'un parmi un moment d'occurrence de placage de lithium, un moment de fin de placage de lithium, un SOC correspondant au moment d'occurrence de placage de lithium et un niveau de gravité de placage de lithium ; et le niveau de gravité de placage de lithium est déterminé sur la base de la durée de placage de lithium et de la valeur de potentiel en temps réel de l'électrode négative de la batterie au lithium.

**13.** Appareil selon l'une quelconque des revendications 7 à 12, dans lequel l'appareil comprend en outre une unité de commande de courant, dans lequel

l'unité de commande de courant est configurée pour régler le courant de charge de la batterie au lithium sur la base de la valeur de potentiel en temps réel de l'électrode négative de la batterie au lithium.

**14.** Appareil selon la revendication 12 ou 13, dans lequel l'appareil comprend en outre l'unité de commande de courant, dans lequel

l'unité de commande de courant est configurée pour déterminer un courant de charge sûr maximum de la batterie au lithium sur la base du moment d'occurrence de placage de lithium et du SOC correspondant au moment d'occurrence de placage de lithium.

**15.** Véhicule électrique, dans lequel le véhicule électrique comprend une batterie au lithium, un dispositif de charge/décharge et l'appareil de détection de placage de lithium dans une batterie au lithium selon l'une quelconque des revendications 7 à 14.

Vehicle 100

**Travel system 102**
- Engine 118
- Transmission apparatus 120
- Energy source 119
- Wheel 121

**Sensor system 104**
- Positioning system 122
- Inertial measurement unit 124
- Radar 126
- Laser rangefinder 128
- Camera 130

**Control system 106**
- Steering system 132
- Throttle 134
- Braking unit 136
- Sensor fusion algorithm 138
- Computer vision system 140
- Route control system 142
- Obstacle avoidance system 144

**Peripheral device 108**
- Wireless communication system 146
  - T-Box
- Vehicle-mounted computer 148
- Microphone 150
- Speaker 152

**Computer system 112**
- Processor 123
- Memory 114
  - Instruction 125

Power supply 110

User interface 116

FIG. 1

FIG. 2

Determine, based on a state of health SOH of a lithium battery, a temperature of the lithium battery, and a correspondence between the SOH of the lithium battery and the temperature of the lithium battery and a target parameter, a target parameter corresponding to the lithium battery — S301

Substitute the target parameter corresponding to the lithium battery into a preset lithium plating estimation model, to obtain a lithium plating estimation model of the lithium battery — S302

Enter a charge current of the lithium battery, a voltage of the lithium battery, the temperature of the lithium battery, and the SOH of the lithium battery into the lithium plating estimation model of the lithium battery, to obtain a real-time potential value of a negative electrode of the lithium battery — S303

Determine that lithium plating occurs in the lithium battery if the real-time potential value of the negative electrode of the lithium battery is less than zero — S304

FIG. 3

Charge a lithium battery at different temperatures and in different SOHs by using a preset charge rate, a first charge rate, a second charge rate, and a third charge rate — S401

Determine corresponding open-circuit voltages OCVs of the lithium battery in different SOCs of the lithium battery and corresponding OCVs of a negative electrode of the lithium battery in different SOCs of the lithium battery — S402

Separately obtain corresponding temperatures and pressure of the lithium battery in different SOCs during charging of the lithium battery at the first charge rate, the second charge rate, or the third charge rate — S403

Determine lithium plating effect pressure of the lithium battery in different SOCs based on the corresponding temperatures and pressure of the lithium battery in different SOCs — S404

Determine a polarization voltage of the negative electrode of the lithium battery and a polarization voltage of the lithium battery — S405

Establish a correspondence between a temperature of the lithium battery, a SOH of the lithium battery, and a target parameter — S406

FIG. 4

FIG. 5(a)

FIG. 5(b)

FIG. 5(c)

FIG. 6

FIG. 7(a)

FIG. 7(b)

FIG. 7(c)

FIG. 8

FIG. 9

```
┌─────────────────────────────────────────────┐
│    ┌───────────────────────────┐             │
│    │   Target parameter        │ ～ 1001     │
│    │   determining unit        │             │
│    └───────────────────────────┘             │
│                 │                            │
│    ┌───────────────────────────┐             │
│    │   Model determining unit  │ ～ 1002     │
│    └───────────────────────────┘             │
│                 │                            │
│    ┌───────────────────────────┐             │
│    │   Diagnostic parameter    │ ～ 1003     │
│    │   obtaining unit          │             │
│    └───────────────────────────┘             │
│                 │                            │
│    ┌───────────────────────────┐             │
│    │   Lithium plating diagnosis│ ～ 1004    │
│    │   unit                    │             │
│    └───────────────────────────┘             │
│                 │                            │
│    ┌───────────────────────────┐             │
│    │   Current control unit    │ ～ 1005     │
│    └───────────────────────────┘             │
│                 │                            │
│    ┌───────────────────────────┐             │
│    │   Lithium plating alarm unit│ ～ 1006   │
│    └───────────────────────────┘             │
└─────────────────────────────────────────────┘
```

FIG. 10

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2019229378 A1